# DEMANDE DE BREVET EUROPEEN

(11) **EP 4 704 501 A1**
(43) Date de publication de la demande: **04.03.2026**
(21) Numéro de dépôt: 25198776.4
(22) Date de dépôt: 28.08.2025
(51) Int. Cl.: H05K 5/02, E06B 9/38, E06B 9/42, E06B 9/72

(54) **DISPOSITIF D'ALIMENTATION EN ÉNERGIE ÉLECTRIQUE, DISPOSITIF D'ENTRAÎNEMENT MOTORISÉ COMPRENANT UN TEL DISPOSITIF D'ALIMENTATION EN ÉNERGIE ÉLECTRIQUE, ET DISPOSITIF D'OCCULTATION ASSOCIÉ**

(30) Priorité: 29.08.2024 FR 2409225
(71) Demandeur: Somfy Activites SA, 74300 Cluses (FR)
(72) Inventeur: COSTANTINI, Guillaume, 74300 CLUSES (FR); BONNAUD, Matthieu, 74300 CLUSES (FR)
(74) Mandataire: Lavoix

(57) **Abrégé**

Un dispositif d'alimentation en énergie électrique comprend un boîtier, un panneau photovoltaïque, qui est fixé sur le boîtier, et un dispositif de fixation (49), qui comprend un support de fixation (50), un dispositif de maintien (51) et un capot (54). Le support (50) comprend une pluralité de premiers éléments de verrouillage. Le dispositif de maintien (51) comprend au moins un deuxième élément de verrouillage (53), qui coopère avec l'un des premiers éléments de verrouillage. Le dispositif de maintien (51) est fixé sur le capot (54). Le capot (54) est fixé de manière démontable sur le boîtier. En outre, le support (50) est disposé entre le boîtier et le capot (54), de sorte, d'une part, à pouvoir coulisser le support (50) entre le boîtier et le capot (54) et, d'autre part, à maintenir en position le support (50) par le dispositif de maintien (51).

## Description

La présente invention concerne un dispositif d'alimentation en énergie électrique.

La présente invention concerne également un dispositif d'entraînement motorisé comprenant un tel dispositif d'alimentation en énergie électrique, ainsi qu'un dispositif d'occultation comprenant un tel dispositif d'entraînement motorisé.

De manière générale, la présente invention concerne le domaine des dispositifs d'occultation comprenant un dispositif d'entraînement motorisé mettant en mouvement un écran, entre au moins une première position et au moins une deuxième position.

Un dispositif d'entraînement motorisé comprend un actionneur électromécanique d'un élément mobile de fermeture, d'occultation ou de protection solaire, tel qu'un volet, une porte, une grille, un store ou tout autre matériel équivalent, appelé par la suite écran.

On connaît déjà le document WO 2010/119876 A1 qui décrit un dispositif d'alimentation en énergie électrique. Le dispositif d'alimentation en énergie électrique comprend un boîtier, un panneau photovoltaïque et un dispositif de fixation. Le panneau photovoltaïque est fixé sur le boîtier. Le dispositif de fixation comprend un support de fixation et un dispositif de maintien. Le support de fixation comprend une pluralité de premiers éléments de verrouillage. Le dispositif de maintien comprend deux deuxièmes éléments de verrouillage. Chacun des deuxièmes éléments de verrouillage coopère avec l'un des premiers éléments de verrouillage.

Ce dispositif d'alimentation en énergie électrique présente l'inconvénient que le dispositif de fixation est intégré au boîtier, sur lequel est fixé le panneau photovoltaïque, étant donné que le dispositif de maintien est logé à l'intérieur du boîtier.

Ainsi, le support de fixation est configuré, d'une part, pour coulisser suivant un mouvement de translation à l'intérieur du boîtier et, d'autre part, pour être maintenu par le dispositif de maintien, lors de la coopération des deux deuxièmes éléments de verrouillage avec l'un des premiers éléments de verrouillage, qui sont disposés à l'intérieur du boîtier.

Cette construction du dispositif d'alimentation en énergie électrique implique d'assembler obligatoirement le sous-ensemble formé par le boîtier et le panneau photovoltaïque sur une paroi avec le dispositif de fixation et, plus particulièrement, avec le support de fixation.

Par conséquent, le boîtier ne peut pas être fixé sur la même paroi ou une autre paroi, telle que, par exemple, une paroi d'un caisson d'un dispositif d'occultation, un mur d'un bâtiment, l'une des coulisses latérales d'un dispositif d'occultation, une vitre d'une fenêtre ou un cadre dormant d'une fenêtre, au moyen d'un autre dispositif de fixation, pouvant être mis en œuvre, par exemple, par collage, soit au moyen d'un adhésif, soit au moyen d'une couche de colle, par encliquetage élastique, par emboîtement, par vissage ou par rivetage sur la paroi.

La présente invention a pour but de résoudre les inconvénients précités et de proposer un dispositif d'alimentation en énergie électrique, un dispositif d'entraînement motorisé comprenant un tel dispositif d'alimentation en énergie électrique, ainsi qu'un dispositif d'occultation comprenant un tel dispositif d'entraînement motorisé, permettant de dissocier intégralement un dispositif de fixation du dispositif d'alimentation en énergie électrique par rapport à un boîtier, sur lequel est fixé un panneau photovoltaïque.

A cet égard, la présente invention vise, selon un premier aspect, un dispositif d'alimentation en énergie électrique,
le dispositif d'alimentation en énergie électrique comprenant au moins :
   - un boîtier,
   - un panneau photovoltaïque, le panneau photovoltaïque étant fixé sur le boîtier, et
   - un dispositif de fixation,
le dispositif de fixation comprenant au moins :
   - un support de fixation, le support de fixation comprenant au moins une pluralité de premiers éléments de verrouillage, et
   - un dispositif de maintien, le dispositif de maintien comprenant au moins un deuxième élément de verrouillage, ledit au moins un deuxième élément de verrouillage coopérant avec l'un des premiers éléments de verrouillage.

Selon l'invention, le dispositif de fixation comprend, en outre, un capot. Le dispositif de maintien est fixé sur le capot. Le capot est fixé de manière démontable sur le boîtier. En outre, le support de fixation est disposé entre le boîtier et le capot, de sorte, d'une part, à pouvoir coulisser le support de fixation entre le boîtier et le capot suivant un mouvement de translation et, d'autre part, à maintenir en position le support de fixation par le dispositif de maintien, lors de la coopération dudit au moins un deuxième élément de verrouillage avec l'un des premiers éléments de verrouillage.

Ainsi, cette construction du dispositif d'alimentation en énergie électrique permet de dissocier intégralement le dispositif de fixation par rapport au boîtier, sur lequel est fixé le panneau photovoltaïque.

De cette manière, cette construction du dispositif d'alimentation en énergie électrique permet de régler la position du panneau photovoltaïque par rapport au support de fixation au moyen de différents crans de réglage obtenus par la coopération dudit au moins un deuxième élément de verrouillage du dispositif de maintien coopérant avec l'un des premiers éléments de verrouillage du support de fixation.

En outre, le panneau photovoltaïque est suspendu par rapport au support de fixation par l'intermédiaire du boîtier, du dispositif de maintien et du capot.

Par ailleurs, le panneau photovoltaïque peut être monté sur le support de fixation ou détaché du support de fixation en faisant coulisser, suivant le mouvement de translation, un sous-ensemble formé par le panneau photovoltaïque, le boîtier, le dispositif de maintien et le capot par rapport au support de fixation.

Selon une caractéristique avantageuse de l'invention, la fixation du capot sur le boîtier est mise en œuvre par encliquetage élastique.

Selon une autre caractéristique avantageuse de l'invention, le boîtier comprend au moins une première rainure et une deuxième rainure. Le capot comprend au moins un premier bord, un deuxième bord, un premier ergot et un deuxième ergot. Le deuxième bord est opposé au premier bord. Le ou chaque premier ergot est disposé le long du premier bord. Le ou chaque premier ergot est déformable élastiquement. Le ou chaque deuxième ergot est disposé le long du deuxième bord. En outre, la fixation du capot sur le boîtier est mise en œuvre par l'insertion du ou de chaque premier ergot dans la première rainure et par l'insertion du ou de chaque deuxième ergot dans la deuxième rainure.

Selon une autre caractéristique avantageuse de l'invention, le capot comprend, en outre, deux découpes. Le dispositif de maintien comprend, en outre, deux éléments en saillie et au moins une fente. Chaque élément en saillie est logé à l'intérieur de l'une des découpes. En outre, une partie du dispositif de maintien est déformée élastiquement au moyen de la fente, lors de l'insertion de chaque élément en saillie à l'intérieur de l'une des découpes du capot.

Selon une autre caractéristique avantageuse de l'invention, le support de fixation est sécable au moyen de lignes de brisure.

Selon une autre caractéristique avantageuse de l'invention, chacune des lignes de brisure s'étend au travers de l'un des premiers éléments de verrouillage.

La présente invention vise, selon un deuxième aspect, un dispositif d'entraînement motorisé,
le dispositif d'entraînement motorisé comprenant au moins :
   - un actionneur électromécanique,
   - une unité électronique de contrôle, et
   - un dispositif d'alimentation en énergie électrique,
l'actionneur électromécanique comprenant au moins un moteur électrique.

Selon l'invention, le dispositif d'alimentation en énergie électrique est conforme à l'invention et tel que mentionné ci-dessus. Le dispositif d'alimentation en énergie électrique comprend, en outre, une batterie, l'unité électronique de contrôle et le moteur électrique étant alimentés en énergie électrique à partir de la batterie.

Ce dispositif d'entraînement motorisé présente des caractéristiques et avantages analogues à ceux décrits précédemment en relation avec le dispositif d'alimentation en énergie électrique selon l'invention.

Selon une autre caractéristique avantageuse de l'invention, la batterie est alimentée en énergie électrique au moyen du panneau photovoltaïque.

La présente invention vise, selon un troisième aspect, un dispositif d'occultation, le dispositif d'occultation comprenant au moins :
- un écran, et
- un dispositif d'entraînement motorisé.

Selon l'invention, le dispositif d'entraînement motorisé est conforme à l'invention et tel que mentionné ci-dessus, l'écran étant configuré pour être entraîné en déplacement par l'actionneur électromécanique du dispositif d'entraînement motorisé.

Selon une autre caractéristique avantageuse de l'invention, le dispositif d'occultation comprend, en outre, au moins un caisson. L'actionneur électromécanique est logé à l'intérieur du caisson. Le support de fixation comprend au moins une première paroi, une deuxième paroi et une butée. La deuxième paroi est reliée à la première paroi, de sorte à former un coin entre la deuxième paroi et la première paroi. La ou chaque butée est ménagée dans le coin. En outre, le caisson est en appui contre la ou chaque butée.

D'autres particularités et avantages de l'invention apparaîtront encore dans la description ci-après, faite en référence aux dessins annexés, donnés à titre d'exemples non limitatifs et dans lesquels :
[Fig 1] la figure 1 est une vue schématique en coupe transversale d'une installation d'occultation conforme à un mode de réalisation de l'invention ;
[Fig 2] la figure 2 est une vue schématique en perspective de l'installation d'occultation illustrée à la figure 1 ;
[Fig 3] la figure 3 est une vue schématique en perspective d'un dispositif d'entraînement motorisé conforme à l'invention de l'installation d'occultation illustrée aux figures 1 et 2, ce dispositif d'entraînement motorisé comprenant un actionneur électromécanique et un tube d'enroulement ;
[Fig 4] la figure 4 est une vue schématique en coupe du dispositif d'entraînement motorisé illustré à la figure 3, selon un plan de coupe passant par un axe de rotation d'un arbre de sortie de l'actionneur électromécanique, cette vue schématique en coupe étant interrompue localement ;
[Fig 5] la figure 5 est une première vue schématique en perspective d'un dispositif d'alimentation en énergie électrique conforme à l'invention de l'installation d'occultation illustrée aux figures 1 et 2, selon un premier angle de vue ;
[Fig 6] la figure 6 est une deuxième vue schématique en perspective du dispositif d'alimentation en énergie électrique illustré à la figure 5, selon un deuxième angle de vue, qui est différent du premier angle de vue ;
[Fig 7] la figure 7 est une vue schématique en perspective et éclatée d'un dispositif de fixation du dispositif d'alimentation en énergie électrique illustré aux figures 5 et 6 ;
[Fig 8] la figure 8 est une vue schématique en perspective et à plus grande échelle d'un support de fixation du dispositif de fixation illustré aux figures 5 à 7, selon un angle de vue différent de celui des figures 5 à 7 ;
[Fig 9] la figure 9 est une vue schématique en coupe du dispositif d'alimentation en énergie électrique illustré aux figures 5 et 6, où le support de fixation est fixé contre un plafond d'un bâtiment ; et [Fig 10] la figure 10 est une vue schématique en coupe du dispositif d'alimentation en énergie électrique illustré aux figures 5 et 6, où le support de fixation est fixé contre un coffre d'un dispositif d'occultation.

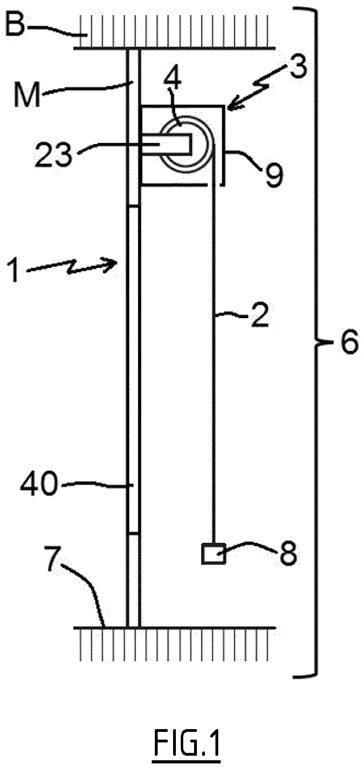

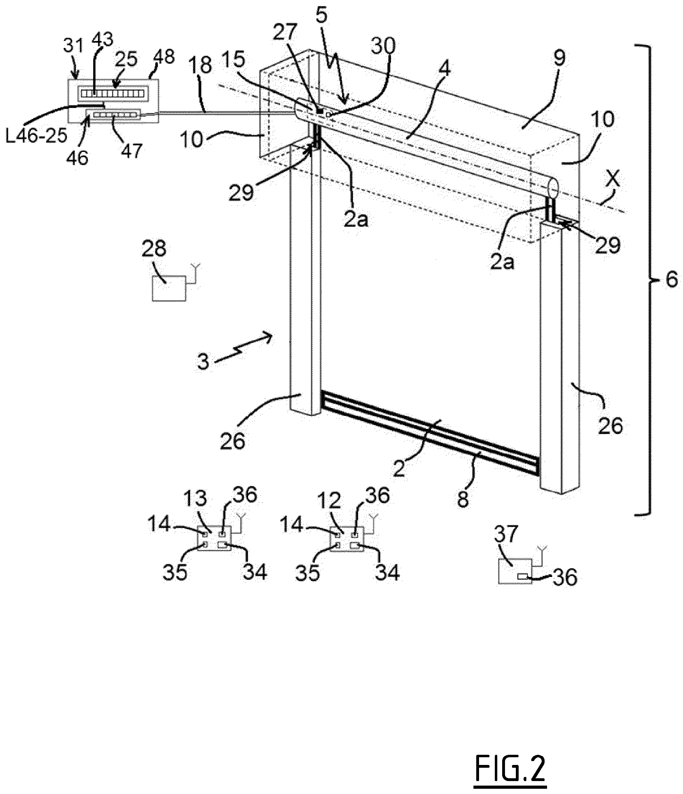

On décrit tout d'abord, en référence aux figures 1 et 2, une installation d'occultation 6 conforme à un mode de réalisation de l'invention. Cette installation d'occultation 6 comprend au moins un dispositif d'occultation 3. Cette installation d'occultation 6, installée dans un bâtiment B, comporte au moins une ouverture 1, dans laquelle est disposée une fenêtre 40 ou une porte, non représentée. Cette installation d'occultation 6 est équipée d'un écran 2 appartenant au dispositif d'occultation 3, en particulier un store motorisé. L'écran 2 est configuré pour se déplacer, autrement dit se déplace, en vis-à-vis de la fenêtre 40 ou de la porte.

Une installation de fermeture et une installation de protection solaire sont des exemples d'installations d'occultation. De même, un dispositif de fermeture et un dispositif de protection solaire sont des exemples de dispositifs d'occultation.

L'installation de fermeture, d'occultation ou de protection solaire est par la suite appelée « installation d'occultation » 6.

Le dispositif de fermeture, d'occultation ou de protection solaire est par la suite appelé « dispositif d'occultation » 3. Le dispositif d'occultation 3 comprend l'écran 2.

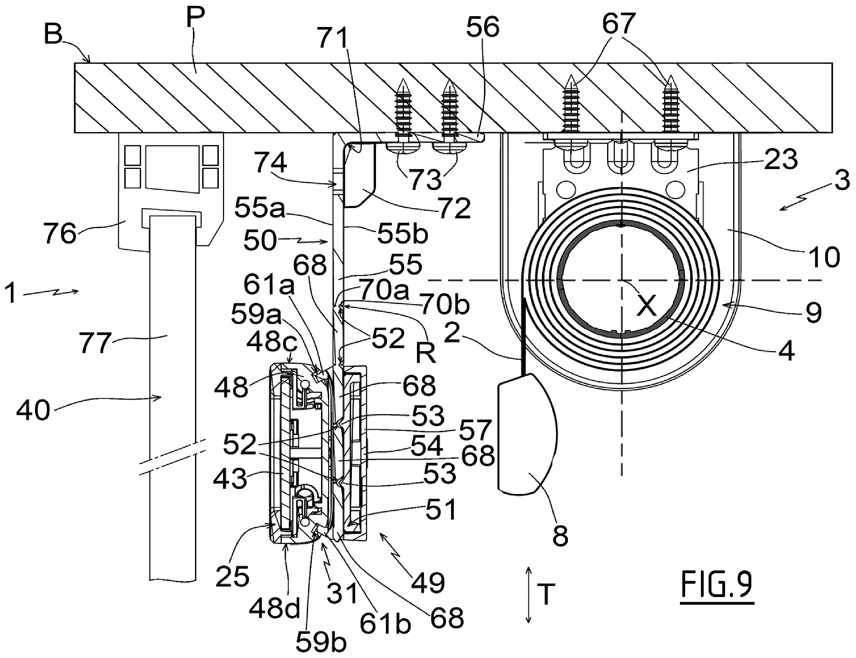

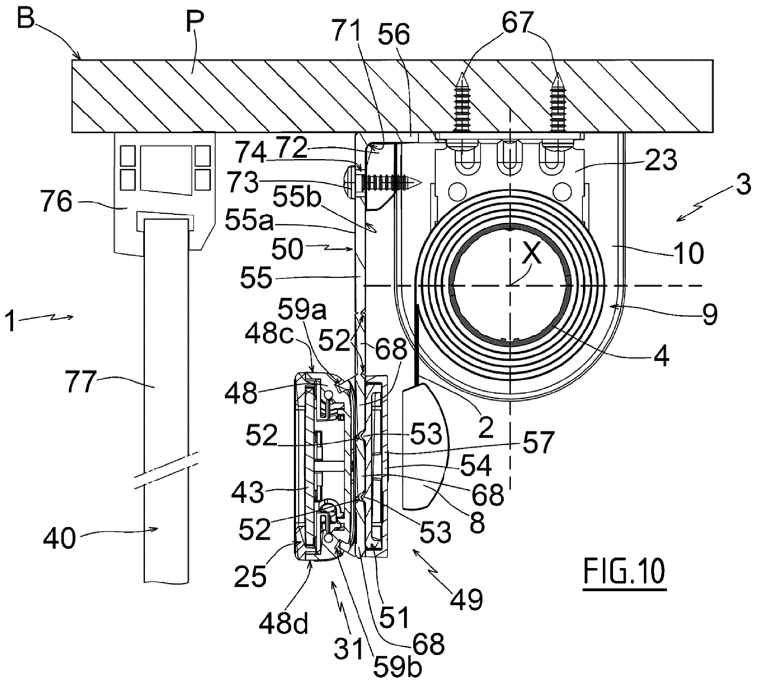

Avantageusement, la fenêtre 40 comprend au moins un cadre dormant 76 et au moins une vitre 77, comme illustré uniquement aux figures 9 et 10. La vitre 77 est disposée à l'intérieur du cadre dormant 76, en particulier dans une configuration assemblée de la fenêtre 40.

Ici et comme illustré aux figures 9 et 10, la vitre 77 est montée dans le cadre dormant 76. Dans un tel cas, la vitre 77 est fixe par rapport au cadre dormant 76.

En variante, non représentée, la fenêtre 40 comprend, en outre, au moins un ouvrant. La vitre 77 est montée dans un cadre de l'ouvrant. Dans un tel cas, la vitre 77 est mobile par rapport au cadre dormant 76, en particulier selon un mouvement de rotation, notamment dans le cas d'une fenêtre oscillante ou battante, ou selon un mouvement de translation, notamment dans le cas d'une fenêtre coulissante selon une direction horizontale ou verticale, ou selon deux mouvements de rotation, notamment dans le cas d'une fenêtre oscillo-battante.

Ici, le dispositif d'occultation 3 est disposé à l'intérieur du bâtiment B et, plus particulièrement, fixé sur une face intérieure du cadre dormant 76 de la fenêtre 40, ce qui n'est pas illustré sur les figures, sur une face intérieure d'un mur M du bâtiment B, comme illustré à la figure 1, ou sur un plafond P du bâtiment B, comme illustré aux figures 9 et 10. L'écran 2 est configuré pour se déployer en vis-à-vis de la fenêtre 40 du bâtiment B, c'est-à-dire pour recouvrir la fenêtre 40 dans une configuration déployée.

Le dispositif d'occultation 3 peut être un store, notamment un store comprenant une toile enroulable, une toile plissée ou alvéolée, ou des lames pouvant être orientables, un volet roulant ou un volet battant.

La présente invention s'applique à tous les types de dispositif d'occultation 3, pouvant être disposés soit à l'intérieur du bâtiment B, soit à l'extérieur du bâtiment B, soit avec une première partie des dispositifs d'occultation 3 disposée à l'intérieur du bâtiment B et avec une deuxième partie des dispositifs d'occultation 3 disposée à l'extérieur du bâtiment B.

Ici, l'installation d'occultation 6 comprend le dispositif d'occultation 3.

On décrit, en référence aux figures 1 et 2, un store motorisé enroulable qui forme un dispositif d'occultation 3.

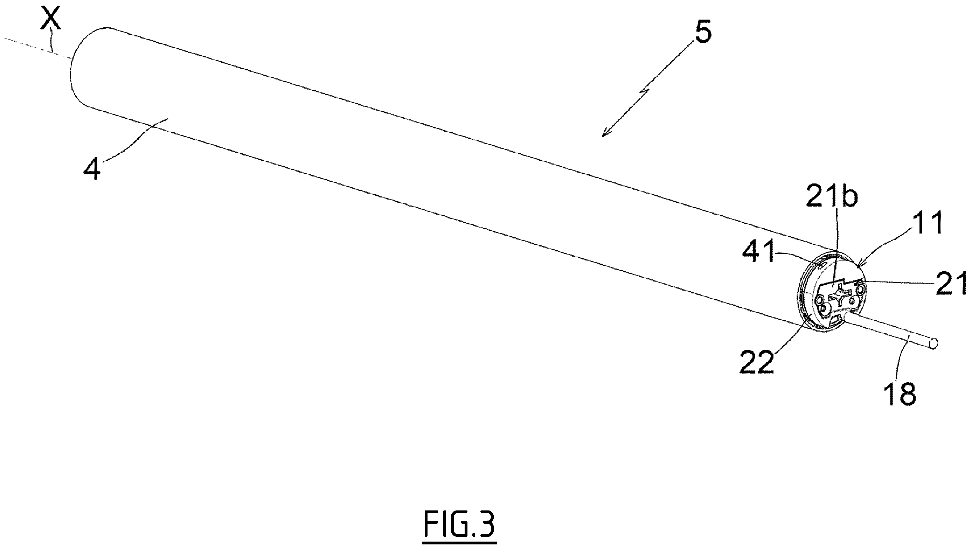

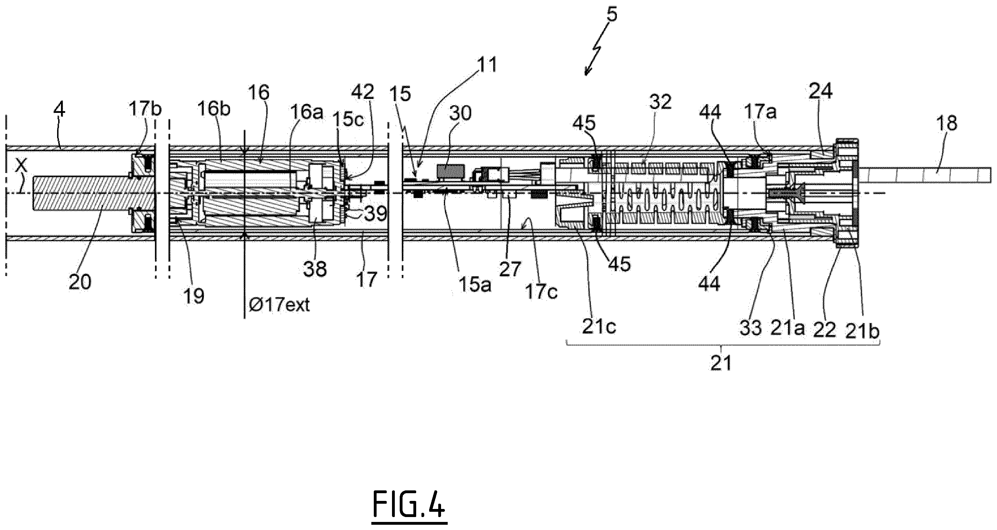

Avantageusement, le dispositif d'occultation 3 comprend un dispositif d'entraînement motorisé 5. Le dispositif d'entraînement motorisé 5 comprend un actionneur électromécanique 11 illustré aux figures 3 et 4.

L'écran 2 est configuré pour être déplacé, autrement dit est déplacé, au moyen du dispositif d'entraînement motorisé 5 et, plus particulièrement, de l'actionneur électromécanique 11.

Ici, le dispositif d'entraînement motorisé 5 et, par conséquent, le dispositif d'occultation 3 comprend, en outre, un tube d'enroulement 4. En outre, le tube d'enroulement 4 est agencé de sorte à être entraîné en rotation, autrement dit est entraîné en rotation, par l'actionneur électromécanique 11.

Ici, l'écran 2 est enroulable sur le tube d'enroulement 4.

Ainsi, l'écran 2 du dispositif d'occultation 3 est enroulé sur le tube d'enroulement 4 ou déroulé autour de celui-ci, le tube d'enroulement 4 étant entraîné par le dispositif d'entraînement motorisé 5, en particulier par l'actionneur électromécanique 11.

De cette manière, l'écran 2 est mobile entre une position enroulée, en particulier haute, et une position déroulée, en particulier basse, et inversement.

L'écran 2 du dispositif d'occultation 3 est un écran de fermeture, d'occultation et/ou de protection solaire, s'enroulant et se déroulant autour du tube d'enroulement 4.

Avantageusement, le dispositif d'occultation 3 comprend un dispositif de maintien 9, 23.

Avantageusement, le dispositif de maintien 9, 23 peut comprendre deux supports 23. Un support 23 est disposé à chaque extrémité du tube d'enroulement 4, en particulier dans une configuration assemblée du dispositif d'occultation 3.

Ainsi, le tube d'enroulement 4 est maintenu par l'intermédiaire des supports 23. Un seul des supports 23 est visible aux figures 1, 9 et 10 et ceux-ci ne sont pas représentés à la figure 2. Les supports 23 permettent de lier mécaniquement le dispositif d'occultation 3 à la structure du bâtiment B, notamment au mur M ou au plafond P du bâtiment B.

Dans les deux exemples de réalisation illustrés aux figures 9 et 10, chaque support 23 est fixé au plafond P du bâtiment B par vissage, en particulier au moyen de vis de fixation 67, en l'occurrence au nombre de deux.

Le type et le nombre d'éléments de fixation de chaque support à la structure du bâtiment ne sont pas limitatifs et peuvent être différents. Le type d'éléments de fixation peut être, par exemple, par collage ou par aimantation. Le nombre d'éléments de fixation peut être, par exemple, supérieur ou égal à trois.

Avantageusement, le dispositif de maintien 9, 23 peut comprendre un caisson 9. En outre, le tube d'enroulement 4 et au moins une partie de l'écran 2 sont logés à l'intérieur du caisson 9, en particulier dans la configuration assemblée du dispositif d'occultation 3.

De manière générale, le caisson 9 est disposé au-dessus de l'ouverture 1, ou encore en partie supérieure de l'ouverture 1.

Ici et comme illustré aux figures 1, 9 et 10, les supports 23 sont également logés à l'intérieur du caisson 9.

Avantageusement, le caisson 9 comprend deux joues 10, telles qu'illustrées aux figures 2, 9 et 10, dont une seule est visible aux figures 9 et 10. Une joue 10 est disposée à chaque extrémité du caisson 9, en particulier dans la configuration assemblée du dispositif d'occultation 3.

En variante, représentée à la figure 2, le tube d'enroulement 4 est maintenu par l'intermédiaire du caisson 9, en particulier par l'intermédiaire des joues 10 du caisson 9, sans utiliser des supports, tels que les supports 23 mentionnés ci-dessus.

Avantageusement, l'actionneur électromécanique 11 est logé, autrement dit est monté, à l'intérieur du caisson 9, en particulier dans la configuration assemblée du dispositif d'occultation 3.

Avantageusement, le dispositif d'occultation 3 peut également comprendre deux coulisses latérales 26, comme illustré uniquement à la figure 2. Chaque coulisse latérale 26 comprend une gorge 29. Chaque gorge 29 de l'une des coulisses latérales 26 coopère, autrement dit est configurée pour coopérer, avec un bord latéral 2a de l'écran 2, en particulier dans la configuration assemblée du dispositif d'occultation 3, de sorte à guider l'écran 2, lors de l'enroulement et du déroulement de l'écran 2 autour du tube d'enroulement 4.

L'actionneur électromécanique 11 est, par exemple, de type tubulaire. Celui-ci permet de mettre en rotation le tube d'enroulement 4 autour d'un axe de rotation X, de sorte à déplacer, en particulier dérouler ou enrouler, l'écran 2 du dispositif d'occultation 3.

Dans un état monté du dispositif d'occultation 3, l'actionneur électromécanique 11 est inséré dans le tube d'enroulement 4.

Avantageusement, le dispositif d'occultation 3 comprend, en outre, une barre de charge 8. La barre de charge 8 est configurée pour exercer une tension sur l'écran 2.

Le store enroulable, qui forme le dispositif d'occultation 3, comporte une toile, formant l'écran 2 du store enroulable 3. Une première extrémité de l'écran 2, en particulier l'extrémité supérieure de l'écran 2, dans la configuration assemblée du dispositif d'occultation 3, est fixée au tube d'enroulement 4. En outre, une deuxième extrémité de l'écran 2, en particulier l'extrémité inférieure de l'écran 2, dans la configuration assemblée du dispositif d'occultation 3, est fixée à la barre de charge 8.

Ici, la toile formant l'écran 2 est réalisée à partir d'un matériau textile.

Dans un exemple de réalisation, non représenté, la première extrémité de l'écran 2 présente un ourlet au travers duquel est disposée une tige, en particulier en matière plastique. Cet ourlet réalisé au niveau de la première extrémité de l'écran 2 est obtenu au moyen d'une couture de la toile formant l'écran 2. Lors de l'assemblage de l'écran 2 sur le tube d'enroulement 4, l'ourlet et la tige situés au niveau de la première extrémité de l'écran 2 sont insérés par coulissement dans une rainure, non représentée, ménagée sur la face externe du tube d'enroulement 4, en particulier sur toute la longueur du tube d'enroulement 4, de sorte à solidariser l'écran 2 avec le tube d'enroulement 4 et à pouvoir enrouler et dérouler l'écran 2 autour du tube d'enroulement 4.

Le mode de fixation de l'écran 2 sur le tube d'enroulement 4 n'est pas limitatif et peut être différent. Il peut être mis en œuvre, par exemple, au moyen d'un adhésif ou d'une ou plusieurs articulations fixées, notamment par vissage ou par rivetage, au tube d'enroulement 4.

Quel que soit le mode de réalisation, la première extrémité de l'écran 2 est disposée au niveau du dispositif de maintien 9, 23.

Dans le cas d'un store enroulable, la position haute enroulée correspond à une position de fin de course haute prédéterminée, ou encore à la mise en appui de la barre de charge 8 de l'écran 2 contre un bord du caisson 9 du store enroulable 3, et la position basse déroulée correspond à une position de fin de course basse prédéterminée, ou à la mise en appui de la barre de charge 8 de l'écran 2 contre un seuil 7 de l'ouverture 1, ou encore au déroulement complet de l'écran 2.

Avantageusement, le dispositif d'entraînement motorisé 5 est commandé par une unité de commande. L'unité de commande peut être, par exemple, une unité de commande locale 12 ou une unité de commande centrale 13.

Avantageusement, l'unité de commande locale 12 peut être reliée, en liaison filaire ou non filaire, avec l'unité de commande centrale 13.

Avantageusement, l'unité de commande centrale 13 peut piloter l'unité de commande locale 12, ainsi que d'autres unités de commande locales similaires et réparties dans le bâtiment B.

Le dispositif d'entraînement motorisé 5 est, de préférence, configuré pour exécuter les commandes de déplacement, notamment de déroulement ou d'enroulement, de l'écran 2 du dispositif d'occultation 3, pouvant être émises, notamment, par l'unité de commande locale 12 ou l'unité de commande centrale 13.

L'installation d'occultation 6 comprend soit l'unité de commande locale 12, soit l'unité de commande centrale 13, soit l'unité de commande locale 12 et l'unité de commande centrale 13.

On décrit à présent, plus en détail et en référence aux figures 2 à 4, le dispositif d'entraînement motorisé 5, y compris l'actionneur électromécanique 11, appartenant à l'installation d'occultation 6 et, plus particulièrement, au dispositif d'occultation 3 illustré aux figures 1 et 2.

Avantageusement, l'actionneur électromécanique 11 comprend un moteur électrique 16.

Avantageusement, le moteur électrique 16 comprend un rotor 16a et un stator 16b, positionnés de manière coaxiale autour de l'axe de rotation X, qui est également l'axe de rotation du tube d'enroulement 4 en configuration montée du dispositif d'entraînement motorisé 5, comme mentionné ci-dessus.

Avantageusement, le moteur électrique 16 peut être de type sans balais à commutation électronique, appelé également « BLDC » (acronyme du terme anglo-saxon BrushLess Direct Current) ou « synchrone à aimants permanents », ou de type à courant continu.

Des moyens de commande de l'actionneur électromécanique 11, permettant le déplacement de l'écran 2 du dispositif d'occultation 3, sont constitués par au moins une unité électronique de contrôle 15. Cette unité électronique de contrôle 15 appartient au dispositif d'entraînement motorisé 5 et, avantageusement, à l'actionneur électromécanique 11 et est apte à mettre en fonctionnement le moteur électrique 16 de l'actionneur électromécanique 11 et, en particulier, à permettre l'alimentation en énergie électrique du moteur électrique 16.

Ainsi, l'unité électronique de contrôle 15 commande, notamment, le moteur électrique 16, de sorte à ouvrir ou fermer l'écran 2, comme décrit précédemment.

Les moyens de commande de l'actionneur électromécanique 11 comprennent des moyens matériels et/ou logiciels.

A titre d'exemple nullement limitatif, les moyens matériels peuvent comprendre au moins un microcontrôleur 30.

Avantageusement, l'unité électronique de contrôle 15 comprend, en outre, un premier module de communication 27, en particulier de réception d'ordres de commande, les ordres de commande étant émis par un émetteur d'ordres, tel que l'unité de commande locale 12 ou l'unité de commande centrale 13, ces ordres étant destinés à commander le dispositif d'entraînement motorisé 5.

Avantageusement, le premier module de communication 27 de l'unité électronique de contrôle 15 est de type sans fil. En particulier, le premier module de communication 27 est configuré pour recevoir des ordres de commande radioélectriques.

Avantageusement, le premier module de communication 27 peut également permettre la réception d'ordres de commande transmis par des moyens filaires.

Avantageusement, l'unité électronique de contrôle 15, l'unité de commande locale 12 et/ou l'unité de commande centrale 13 peuvent être en communication avec une station météorologique, non représentée, disposée à l'intérieur du bâtiment B ou déportée à l'extérieur du bâtiment B, incluant, notamment, un ou plusieurs capteurs pouvant être configurés pour déterminer, par exemple, une température, une luminosité, ou encore une vitesse de vent, dans le cas où la station météorologique est déportée à l'extérieur du bâtiment B.

Avantageusement, l'unité électronique de contrôle 15, l'unité de commande locale 12 et/ou l'unité de commande centrale 13 peuvent également être en communication avec un serveur 28, tel qu'illustré à la figure 2, de sorte à contrôler l'actionneur électromécanique 11 suivant des données mises à disposition à distance par l'intermédiaire d'un réseau de communication, en particulier un réseau internet pouvant être relié au serveur 28.

L'unité électronique de contrôle 15 peut être commandée à partir de l'unité de commande locale 12 et/ou de l'unité de commande centrale 13. L'unité de commande locale 12 et/ou l'unité de commande centrale 13 est pourvue d'un clavier de commande. Le clavier de commande de l'unité de commande locale 12 ou de l'unité de commande centrale 13 comprend un ou plusieurs éléments de sélection 14 et, éventuellement, un ou plusieurs éléments d'affichage 34.

A titre d'exemples nullement limitatifs, les éléments de sélection peuvent être des boutons poussoirs et/ou des touches sensitives. Les éléments d'affichage peuvent être des diodes électroluminescentes et/ou un afficheur, par exemple LCD (acronyme du terme anglo-saxon « Liquid Crystal Display ») ou TFT (acronyme du terme anglo-saxon « Thin Film Transistor »). Les éléments de sélection et d'affichage peuvent être également réalisés au moyen d'un écran tactile.

Avantageusement, l'unité de commande locale 12 et/ou l'unité de commande centrale 13 comprend au moins un deuxième module de communication 36.

Ainsi, le deuxième module de communication 36 de l'unité de commande locale 12 ou de l'unité de commande centrale 13 est configuré pour émettre, autrement dit émet, des ordres de commande, en particulier par des moyens sans fil, par exemple radioélectriques, et/ou par des moyens filaires.

En outre, le deuxième module de communication 36 de l'unité de commande locale 12 ou de l'unité de commande centrale 13 peut également être configuré pour recevoir, autrement dit reçoit, des ordres de commande, en particulier par l'intermédiaire des mêmes moyens.

Avantageusement, le deuxième module de communication 36 de l'unité de commande locale 12 ou de l'unité de commande centrale 13 est configuré pour communiquer, autrement dit communique, avec le premier module de communication 27 de l'unité électronique de contrôle 15.

Ainsi, le deuxième module de communication 36 de l'unité de commande locale 12 ou de l'unité de commande centrale 13 échange des ordres de commande avec le premier module de communication 27 de l'unité électronique de contrôle 15, soit de manière monodirectionnelle, soit de manière bidirectionnelle.

Avantageusement, l'unité de commande locale 12 est un point de commande, pouvant être fixe ou nomade. Un point de commande fixe peut être un boîtier de commande destiné à être fixé sur une façade du mur M du bâtiment B ou sur une face du cadre dormant 76 de la fenêtre 40 ou de la porte. Un point de commande nomade peut être une télécommande, un téléphone intelligent ou une tablette.

Avantageusement, l'unité de commande locale 12 et/ou l'unité de commande centrale 13 comprend, en outre, un contrôleur 35.

Le dispositif d'entraînement motorisé 5, en particulier l'unité électronique de contrôle 15, est, de préférence, configuré pour exécuter des ordres de commande de déplacement, notamment de fermeture ainsi que d'ouverture, de l'écran 2 du dispositif d'occultation 3. Ces ordres de commande peuvent être émis, notamment, par l'unité de commande locale 12 ou par l'unité de commande centrale 13.

Le dispositif d'entraînement motorisé 5 peut être contrôlé par l'utilisateur, par exemple par la réception d'un ordre de commande correspondant à un appui sur le ou l'un des éléments de sélection 14 de l'unité de commande locale 12 ou de l'unité de commande centrale 13.

Avantageusement, l'installation d'occultation 6 comprend, en outre, au moins un capteur 37.

En complément ou en variante, le capteur 37 peut être intégré à la station météorologique.

Avantageusement, le capteur 37 comprend au moins un deuxième module de communication 36, tel que celui décrit en référence à l'unité de commande locale 12 ou à l'unité de commande centrale 13. En outre, le deuxième module de communication 36 du capteur 37 est configuré pour communiquer, autrement dit communique, avec le premier module de communication 27 de l'unité électronique de contrôle 15.

Avantageusement, le capteur 37 peut être, par exemple, un capteur d'éclairement, un capteur de température, un capteur d'humidité ou un capteur de vent.

Ainsi, le dispositif d'entraînement motorisé 5 peut également être contrôlé automatiquement par la réception d'un ordre de commande correspondant à au moins un signal provenant du capteur 37.

En complément ou en variante, le dispositif d'entraînement motorisé 5 peut également être contrôlé automatiquement par la réception d'un ordre de commande correspondant à au moins un signal provenant d'une horloge, non représentée, de l'unité électronique de contrôle 15, en particulier du microcontrôleur 30.

En complément ou en variante, le capteur 37 et/ou l'horloge peuvent être intégrés à l'unité de commande locale 12 ou à l'unité de commande centrale 13.

Avantageusement, l'actionneur électromécanique 11 comprend, en outre, un carter 17, en particulier tubulaire. En outre, le moteur électrique 16 est monté à l'intérieur du carter 17, en particulier dans une configuration assemblée de l'actionneur électromécanique 11.

Ici, le carter 17 est creux. Le carter 17 comprend une première extrémité 17a et une deuxième extrémité 17b. La deuxième extrémité 17b est opposée à la première extrémité 17a.

Avantageusement, l'actionneur électromécanique 11 comprend, en outre, une couronne 24, autrement dit un manchon.

La couronne 24 est disposée, autrement dit est configurée pour être disposée, au voisinage de la première extrémité 17a du carter 17, en particulier dans la configuration assemblée de l'actionneur électromécanique 11.

La couronne 24 forme, autrement dit est configurée pour former ou constituer, un palier de guidage en rotation du tube d'enroulement 4, autour du carter 17 de l'actionneur électromécanique 11, en particulier dans une configuration assemblée du dispositif d'entraînement motorisé 5 et, par conséquent, du dispositif d'occultation 3.

Ici, le carter 17 de l'actionneur électromécanique 11 est de forme cylindrique, notamment de révolution autour de l'axe de rotation X, et est ouvert à chacune de ses extrémités 17a, 17b.

Avantageusement, le carter 17 est un tube présentant une section circulaire.

Ici, le carter 17 est réalisé dans un matériau métallique.

En variante, le carter 17 est réalisé dans une matière plastique.

Avantageusement, l'actionneur électromécanique 11 comprend, en outre, un arbre de sortie 20.

Ici, l'arbre de sortie 20 est disposé, autrement dit est configuré pour être disposé, au voisinage de la deuxième extrémité 17b du carter 17, en particulier dans la configuration assemblée de l'actionneur électromécanique 11.

Avantageusement, l'actionneur électromécanique 11 comprend, en outre, un réducteur 19.

Avantageusement, le réducteur 19 comprend au moins un étage de réduction. L'étage de réduction peut être un train d'engrenages de type épicycloïdal.

Le type et le nombre d'étages de réduction du réducteur ne sont pas limitatifs. Le nombre d'étages de réduction peut être, notamment, égal à un ou supérieur ou égal à deux.

Le réducteur 19 est représenté partiellement à la figure 4, du fait de l'interruption locale de cette figure.

Le réducteur 19 est accouplé, autrement dit est configuré pour être accouplé, avec le moteur électrique 16, en particulier avec le rotor 16a du moteur électrique 16 dans la configuration assemblée de l'actionneur électromécanique 11.

Avantageusement, l'actionneur électromécanique 11 comprend, en outre, un frein, non représenté.

A titre d'exemples nullement limitatifs, le frein peut être un frein à ressort, un frein à came, un frein magnétique ou un frein électromagnétique.

Le frein est configuré pour freiner et/ou pour bloquer en rotation l'arbre de sortie 20, de sorte à réguler la vitesse de rotation du tube d'enroulement 4, lors d'un déplacement de l'écran 2, et à maintenir bloqué le tube d'enroulement 4, lorsque l'actionneur électromécanique 11 est désactivé électriquement.

Ici, le frein est configuré pour être disposé, autrement dit est disposé, en particulier dans la configuration assemblée de l'actionneur électromécanique 11, entre deux étages de réduction du réducteur 19.

En variante, non représentée, le frein est configuré pour être disposé, autrement dit est disposé, en particulier dans la configuration assemblée de l'actionneur électromécanique 11, entre l'unité électronique de contrôle 15 et le moteur électrique 16, autrement dit à l'entrée du moteur électrique 16, ou entre le réducteur 19 et l'arbre de sortie 20, autrement dit à la sortie du réducteur 19, ou encore entre le moteur électrique 16 et le réducteur 19, c'est-à-dire à la sortie du moteur électrique 16.

Avantageusement, le réducteur 19 et, éventuellement, le frein sont montés, autrement dit sont configurés pour être montés, à l'intérieur du carter 17 de l'actionneur électromécanique 11, en particulier dans la configuration assemblée de l'actionneur électromécanique 11.

Avantageusement, l'actionneur électromécanique 11 et, plus particulièrement, l'unité électronique de contrôle 15 comprend, en outre, un dispositif, non représenté, de détection de fin de course et/ou d'obstacle lors du déplacement de l'écran 2. Ce dispositif de détection de fin de course et/ou d'obstacle peut être mécanique ou électronique.

Avantageusement, le dispositif de détection de fin de course et/ou d'obstacle est mis en œuvre au moyen du microcontrôleur 30 de l'unité électronique de contrôle 15 et, en particulier, au moyen d'un algorithme mis en œuvre par ce microcontrôleur 30.

Le tube d'enroulement 4 est entraîné en rotation autour de l'axe de rotation X et du carter 17 de l'actionneur électromécanique 11 en étant soutenu par l'intermédiaire de deux liaisons pivot. La première liaison pivot est réalisée au niveau d'une première extrémité du tube d'enroulement 4 au moyen de la couronne 24. La couronne 24 permet ainsi de réaliser un palier. La deuxième liaison pivot, non représentée, est réalisée au niveau d'une deuxième extrémité du tube d'enroulement 4, opposée à la première extrémité.

Avantageusement, l'actionneur électromécanique 11 comprend, en outre, un support de couple 21.

Ici, le support de couple 21 est disposé au niveau de la première extrémité 17a du carter 17 de l'actionneur électromécanique 11, en particulier dans la configuration assemblée de l'actionneur électromécanique 11.

Le support de couple 21 permet de reprendre les efforts exercés par l'actionneur électromécanique 11, en particulier le couple exercé par l'actionneur électromécanique 11, par rapport à la structure du bâtiment B. Le support de couple 21 permet avantageusement de reprendre, en outre, des efforts exercés par le tube d'enroulement 4, notamment le poids du tube d'enroulement 4, de l'actionneur électromécanique 11 et de l'écran 2, et d'assurer la reprise de ces efforts par la structure du bâtiment B.

Ainsi, le support de couple 21 permet de fixer l'actionneur électromécanique 11 sur le dispositif de maintien 9, 23, en particulier à l'un des supports 23 ou sur l'une des joues 10 du caisson 9.

Avantageusement, le support de couple 21 est en saillie au niveau de la première extrémité 17a du carter 17 de l'actionneur électromécanique 11.

Avantageusement, le support de couple 21 obture, autrement dit est configuré pour obturer, la première extrémité 17a du carter 17, en particulier dans la configuration assemblée de l'actionneur électromécanique 11.

Avantageusement, le support de couple 21 est fixé, autrement dit est configuré pour être fixé, au carter 17 au moyen d'un ou plusieurs éléments de fixation, non représentés, en particulier dans la configuration assemblée de l'actionneur électromécanique 11. Le ou les éléments de fixation peuvent être, notamment, des bossages, des vis de fixation, des éléments de fixation par encliquetage élastique, des rainures emmanchées dans des échancrures ou une combinaison de ces différents éléments de fixation.

Avantageusement, le support de couple 21 comprend une première partie 21a, pouvant également être appelée « point fixe », et une deuxième partie 21b, pouvant également être appelée « tête d'actionneur ».

La première partie 21a du support de couple 21 est assemblée, autrement dit est configurée pour être assemblée, avec le carter 17, en particulier dans la configuration assemblée de l'actionneur électromécanique 11. En outre, la deuxième partie 21b du support de couple 21 est configurée pour être assemblée, autrement dit est assemblée, avec le dispositif de maintien 9, 23, en particulier dans une configuration assemblée de l'actionneur électromécanique 11 dans le dispositif d'occultation 3.

La deuxième partie 21b du support de couple 21 est assemblée, autrement dit est configurée pour être assemblée, sur la première partie 21a du support de couple 21, en particulier dans la configuration assemblée de l'actionneur électromécanique 11.

Dans un autre exemple de réalisation, le support de couple 21 peut être monobloc, autrement dit constitué d'une seule pièce formant les première et deuxième parties 21a, 21b du support de couple 21.

Avantageusement, la deuxième partie 21b du support de couple 21 peut présenter différentes formes extérieures, notamment une forme cannelée, dite « en étoile », autrement dit comprenant des reliefs sur son contour, ou une forme ronde, autrement dit dépourvue de reliefs sur son contour, comme illustrée à la figure 3.

Avantageusement, au moins une portion de la première partie 21a du support de couple 21 est de forme générale cylindrique et est disposée, autrement dit est configurée pour être disposée, à l'intérieur du carter 17, en particulier dans la configuration assemblée de l'actionneur électromécanique 11.

Avantageusement, un diamètre extérieur d'au moins une portion de la deuxième partie 21b du support de couple 21 est égal ou, éventuellement, supérieur au diamètre extérieur Ø17ext du carter 17.

Avantageusement, le support de couple 21 comprend, en outre, une butée 33. En outre, la butée 33 est en appui, autrement dit est configurée pour être en appui, contre le carter 17, au niveau de la première extrémité 17a du carter 17, en particulier dans la configuration assemblée de l'actionneur électromécanique 11.

Ainsi, la butée 33 du support de couple 21 permet de limiter l'enfoncement de la première partie 21a du support de couple 21 dans le carter 17, suivant la direction de l'axe de rotation X.

Ici, la butée 33 du support de couple 21 comprend un épaulement. Plus particulièrement, elle est réalisée sous la forme d'une collerette, en particulier de forme cylindrique et à génératrice rectiligne.

En variante, non représentée, la butée 33 du support de couple 21 peut délimiter les première et deuxième parties 21a, 21b du support de couple 21 l'une par rapport à l'autre.

Ainsi, seule la première partie 21a du support de couple 21 est disposée à l'intérieur du carter 17 de l'actionneur électromécanique 11, suite à l'emmanchement du support de couple 21 à l'intérieur du carter 17, jusqu'à la butée 33, en particulier dans la configuration assemblée de l'actionneur électromécanique 11.

Ici et comme illustré à la figure 4, la couronne 24 est disposée, autrement dit est configurée pour être disposée, autour du support de couple 21, en particulier de la première partie 21a du support de couple 21, notamment dans la configuration assemblée de l'actionneur électromécanique 11. Dans ce cas, la couronne 24 est montée libre en rotation autour du support de couple 21, en particulier de la première partie 21a du support de couple 21.

En variante, non représentée, la couronne 24 est disposée, autrement dit est configurée pour être disposée, autour d'une partie du carter 17, en particulier dans la configuration assemblée de l'actionneur électromécanique 11. Dans ce cas, la couronne 24 est montée libre en rotation autour du carter 17.

Dans une autre variante, non représentée, la couronne 24 est disposée, autrement dit est configurée pour être disposée, d'une part, autour du support de couple 21 et, d'autre part, autour d'une partie du carter 17 de l'actionneur électromécanique 11, en particulier de la première extrémité 17a du carter 17, notamment dans la configuration assemblée de l'actionneur électromécanique 11. Dans un tel cas, la couronne 24 peut être montée libre en rotation, d'une part, autour du support de couple 21 et, d'autre part, autour du carter 17 de l'actionneur électromécanique 11.

Avantageusement, l'unité électronique de contrôle 15 peut être alimentée en énergie électrique au moyen d'un câble d'alimentation électrique 18.

Avantageusement, l'unité électronique de contrôle 15 est disposée au moins en partie à l'intérieur du carter 17 de l'actionneur électromécanique 11.

Par ailleurs, l'unité électronique de contrôle 15 peut être disposée au moins en partie à l'extérieur du carter 17 de l'actionneur électromécanique 11 et, en particulier, montée dans le support de couple 21.

Avantageusement, l'unité électronique de contrôle 15 comprend une première carte électronique 15a et une deuxième carte électronique, non représentée.

Ici, la première carte électronique 15a de l'unité électronique de contrôle 15 est disposée à l'intérieur du carter 17 de l'actionneur électromécanique 11, en particulier dans la configuration assemblée de l'actionneur électromécanique 11. En outre, la deuxième carte électronique est disposée à l'intérieur du support de couple 21 de l'actionneur électromécanique 11, en particulier dans la configuration assemblée de l'actionneur électromécanique 11.

Ici, l'unité électronique de contrôle 15 est dépourvue d'un boîtier de réception de la première carte électronique 15a. En d'autres termes, la première carte électronique 15a n'est pas montée dans un boîtier spécifique. Cette première carte électronique 15a est, d'une part, maintenue, notamment enfichée, dans le support de couple 21, en particulier dans une troisième partie centrale 21c du support de couple 21, comme illustré à la figure 4, et, d'autre part, maintenue, notamment enfichée, dans un support, non représenté, monté en extrémité du moteur électrique 16, en particulier dans la configuration assemblée de l'actionneur électromécanique 11.

Avantageusement, l'actionneur électromécanique 11 comprend, en outre, un module de filtration des vibrations 32.

Ici, le module de filtration des vibrations 32 est intégré au support de couple 21 et, plus particulièrement, est disposé, le long de l'axe de rotation X, entre les première et troisième parties 21a, 21c du support de couple 21.

Ici et comme illustré à la figure 4, le module de filtration des vibrations 32 est, d'une part, assemblé sur le support de couple 21 et, plus particulièrement, fixé sur le support de couple 21, notamment par vissage, au moyen de vis de fixation 44, et, d'autre part, fixé au carter 17 de l'actionneur électromécanique 11, notamment par vissage, au moyen de vis de fixation 45.

En variante, non représentée, le module de filtration des vibrations 32 est distinct du support de couple 21.

Avantageusement, le support de couple 21 comprend, en outre, un couvercle 22. Le couvercle 22 est monté, autrement dit est configuré pour être monté, sur le support de couple 21, notamment sur les première et/ou deuxième parties 21a, 21b du support de couple 21, en particulier dans la configuration assemblée de l'actionneur électromécanique 11.

Avantageusement, le support de couple 21 comprend au moins un logement, non représenté.

Avantageusement, le ou au moins l'un des logements est formé entre les première et deuxième parties 21a, 21b du support de couple 21 et le couvercle 22.

Ici, la deuxième carte électronique est disposée, autrement dit est configurée pour être disposée, à l'intérieur du logement, en particulier dans la configuration assemblée de l'actionneur électromécanique 11.

Avantageusement, le support de couple 21 comprend au moins un dispositif de sélection 41, en particulier un bouton, pouvant être, par exemple, de type poussoir ou magnétique.

Le ou chaque dispositif de sélection 41 est configuré, notamment, pour réaliser un réglage de l'actionneur électromécanique 11 au travers d'un ou plusieurs modes de configuration, pour appairer l'actionneur électromécanique 11 avec une ou plusieurs unités de commande 12, 13, pour réinitialiser un ou plusieurs paramètres, pouvant être, par exemple, une position de fin de course, pour réinitialiser la ou les unités de commande 12, 13 appairées ou encore pour commander le déplacement de l'écran 2.

Ici, le support de couple 21 comprend un seul dispositif de sélection 41.

Le nombre de dispositifs de sélection du support de couple n'est pas limitatif et peut être différent. Il peut être, notamment, supérieur ou égal à deux.

Avantageusement, le support de couple 21 comprend au moins un dispositif d'affichage, non représenté.

Le ou chaque dispositif d'affichage est configuré, notamment, pour afficher une indication visuelle, pouvant être, par exemple, représentative d'un mode de fonctionnement de l'actionneur électromécanique 11, en particulier un mode de configuration ou un mode de commande, ou encore d'un état d'un organe du dispositif d'entraînement motorisé 5.

Ici, le ou chaque dispositif de sélection 41 et le ou chaque dispositif d'affichage sont reliés électriquement, autrement dit sont configurés pour être reliés électriquement, à l'unité électronique de contrôle 15 et, plus précisément, à la deuxième carte électronique de contrôle, en particulier dans la configuration assemblée de l'actionneur électromécanique 11.

En variante, le ou chaque dispositif de sélection 41 et/ou le ou chaque dispositif d'affichage sont reliés électriquement, autrement dit sont configurés pour être reliés électriquement, à la première carte électronique de contrôle 15a, en particulier dans la configuration assemblée de l'actionneur électromécanique 11.

Ici, le support de couple 21 comprend un seul logement, où sont logés le dispositif de sélection 41 et le dispositif d'affichage.

En variante, non représentée, le support de couple 21 peut comprendre un premier logement pour recevoir le dispositif d'affichage et un deuxième logement pour recevoir le dispositif de sélection 41. Le support de couple 21 peut comprendre, en outre, un premier logement par dispositif d'affichage ou un premier logement pour une pluralité de dispositifs d'affichage, dans le cas où le support de couple 21 présente plusieurs dispositifs d'affichage, et, éventuellement, un deuxième logement par dispositif de sélection 41 ou un deuxième logement pour une pluralité de dispositifs de sélection 41, dans le cas où le support de couple 21 présente plusieurs dispositifs de sélection 41.

Avantageusement, l'arbre de sortie 20 de l'actionneur électromécanique 11 est disposé à l'intérieur du tube d'enroulement 4 et au moins en partie à l'extérieur du carter 17 de l'actionneur électromécanique 11.

Ici, une extrémité de l'arbre de sortie 20 est en saillie par rapport au carter 17 de l'actionneur électromécanique 11, en particulier par rapport à la deuxième extrémité 17b du carter 17.

Avantageusement, le dispositif d'entraînement motorisé 5 comprend, en outre, un élément de liaison, non représenté. L'arbre de sortie 20 de l'actionneur électromécanique 11 est configuré pour entraîner en rotation, autrement dit entraîne en rotation, l'élément de liaison, autour de l'axe de rotation X. En outre, l'élément de liaison est configuré pour entraîner en rotation, autrement dit entraîne en rotation, le tube d'enroulement 4, autour de l'axe de rotation X.

Avantageusement, l'élément de liaison est relié, autrement dit est configuré pour être relié, au tube d'enroulement 4, en particulier dans la configuration assemblée du dispositif d'entraînement motorisé 5.

Ici, l'élément de liaison est réalisé sous la forme d'une roue de transmission de couple.

Lors de la mise en fonctionnement de l'actionneur électromécanique 11, le moteur électrique 16 et le réducteur 19 entraînent en rotation, autour de l'axe de rotation X, l'arbre de sortie 20. En outre, l'arbre de sortie 20 entraîne en rotation, autour de l'axe de rotation X, le tube d'enroulement 4 par l'intermédiaire de l'élément de liaison.

Ainsi, le tube d'enroulement 4 entraîne en rotation l'écran 2 du dispositif d'occultation 3, de sorte à ouvrir ou fermer l'ouverture 1.

Avantageusement, l'actionneur électromécanique 11 comprend, en outre, un dispositif de comptage 42. Le dispositif de comptage 42 est configuré pour coopérer, autrement dit coopère, avec l'unité électronique de contrôle 15. En outre, le dispositif de comptage 42 et l'unité électronique de contrôle 15 sont configurés pour déterminer une position, pouvant être appelée « courante », de l'écran 2.

Avantageusement, l'unité électronique de contrôle 15 est configurée pour surveiller au moins un signal provenant du dispositif de comptage 42 à une fréquence prédéterminée, notamment en fonction de la position de l'écran 2.

Ici, le dispositif de comptage 42 est de type magnétique.

Dans un tel cas, le dispositif de comptage 42 peut comprendre une roue codeuse 38 et un ou plusieurs capteurs 39, en particulier à effet Hall.

Ici, la roue codeuse 38 est reliée à une extrémité axiale du rotor 16a du moteur électrique 16. En outre, le ou chaque capteur 39 est assemblé sur une carte électronique de l'unité électronique de contrôle 15, en particulier sur une troisième carte électronique 15c, ou, en variante, sur la première carte électronique 15a.

Ainsi, le dispositif de comptage 42 permet de déterminer le nombre de tours réalisés par le rotor 16a du moteur électrique 16.

Ici, le dispositif de comptage 42 comprend trois capteurs 39, dont seuls deux sont visibles à la figure 4.

Le nombre de capteurs n'est pas limitatif et peut être différent. Il peut être, par exemple, de un ou de deux.

En variante, non représentée, le dispositif de comptage 42 peut être dépourvu de capteurs 39. Dans ce cas, le dispositif de comptage 42 est configuré pour, en coopération avec l'unité électronique de contrôle 15, analyser les signaux de commande d'alimentation en énergie électrique du moteur électrique 16 et déterminer une position, pouvant être appelée « courante », du rotor 16a du moteur électrique 16 et, par conséquent, de l'arbre de sortie 20 de l'actionneur électromécanique 11 et du tube d'enroulement 4.

En variante, non représentée, le dispositif de comptage 42 permet de déterminer le nombre de tours réalisés par l'arbre de sortie 20 de l'actionneur électromécanique 11.

Dans une autre variante ou en complément, la couronne 24 comprend, sur sa face intérieure, une denture, non représentée, configurée pour coopérer, autrement dit coopérant, avec un pignon, non représenté, installé à l'intérieur du support de couple 21 ou, alternativement, à l'intérieur du carter 17 de l'actionneur électromécanique 11. Dans cette variante, la roue codeuse 38 est reliée au pignon, en particulier au moyen d'un arbre. Ainsi, la denture de la couronne 24 est configurée pour entraîner en rotation, autrement dit entraîne en rotation, le pignon, de sorte à compter le nombre de tours du tube d'enroulement 4. Dans ce cas, la denture de la couronne 24 et le pignon font partie du dispositif de comptage 42.

Le dispositif de comptage 42 permet également de déterminer le sens de rotation du tube d'enroulement 4 et/ou de gérer les positions de fin de course de l'écran 2.

Le type du dispositif de comptage n'est pas limitatif et peut être différent, en particulier optique, par exemple un encodeur équipé d'un ou plusieurs capteurs optiques, ou temporel.

Le dispositif d'occultation 3 et, plus particulièrement, le dispositif d'entraînement motorisé 5 comprend, en outre, un dispositif d'alimentation en énergie électrique 31, visible aux figures 2, 5, 6, 9 et 10.

Le dispositif d'alimentation en énergie électrique 31 est relié électriquement à une charge électrique, en l'occurrence à l'actionneur électromécanique 11, au moyen du câble d'alimentation électrique 18.

Ainsi, le dispositif d'alimentation en énergie électrique 31 est configuré pour alimenter, autrement dit alimente, en énergie électrique l'actionneur électromécanique 11 et, plus particulièrement, l'unité électronique de contrôle 15 et le moteur électrique 16.

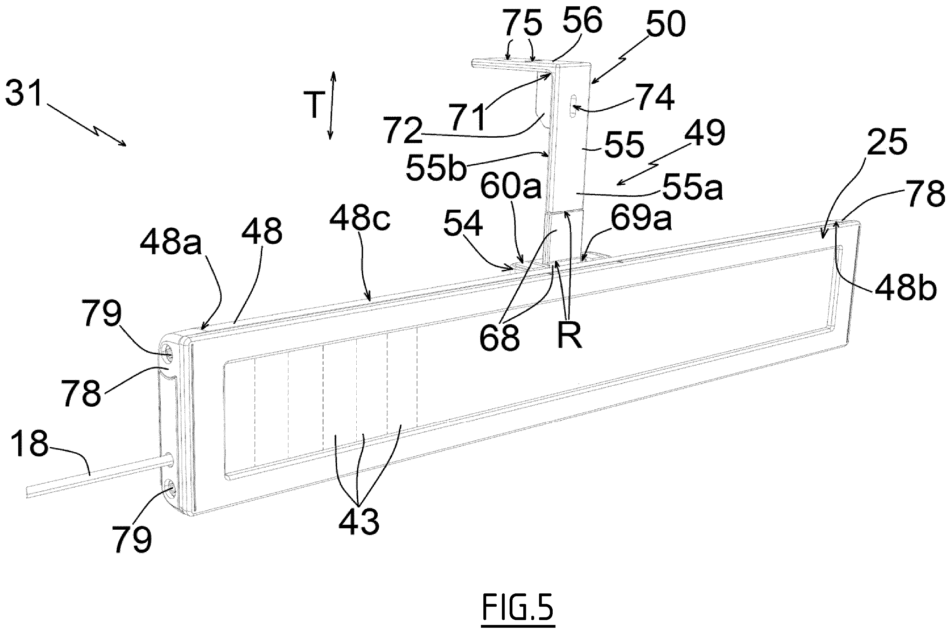

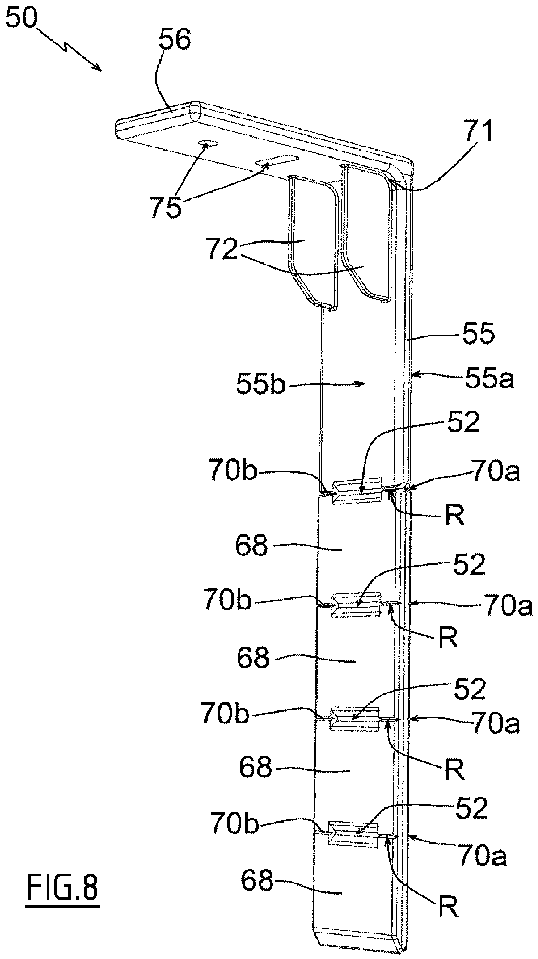

Le dispositif d'alimentation en énergie électrique 31 comprend au moins un boîtier 48, un panneau photovoltaïque 25 et un dispositif de fixation 49, tel qu'illustré aux figures 5 à 10.

Avantageusement, le boîtier 48 comprend une première extrémité 48a et une deuxième extrémité 48b. La deuxième extrémité 48b est opposée à la première extrémité 48a.

Avantageusement, le dispositif d'alimentation en énergie électrique 31 comprend, en outre, deux embouts 78. Chaque embout 78 est fixé, autrement dit est configuré pour être fixé, au niveau de l'une des première et deuxième extrémités 48a, 48b du boîtier 48, en particulier dans une configuration assemblée du dispositif d'alimentation en énergie électrique 31.

La fixation de chaque embout 78 à l'une des première et deuxième extrémités 48a, 48b du boîtier 48 est mise en œuvre par vissage au moyen de vis de fixation 79.

Le type de fixation de l'embout à l'une des première et deuxième extrémités du boîtier n'est pas limitatif et peut être différent. Il peut être, par exemple, par encliquetage élastique, par emboîtement ou par rivetage.

Le panneau photovoltaïque 25 est disposé, autrement dit est configuré pour être disposé, pour que des cellules photovoltaïques 43 de celui-ci soient en vis-à-vis de la vitre 77 de la fenêtre 40 au moyen du dispositif de fixation, en particulier dans une configuration assemblée du dispositif d'alimentation en énergie électrique 31 par rapport à l'installation d'occultation 6.

Le panneau photovoltaïque 25 est fixé, autrement dit est configuré pour être fixé ou assemblé, sur le boîtier 48, en particulier dans la configuration assemblée du dispositif d'alimentation en énergie électrique 31.

La fixation du panneau photovoltaïque 25 sur le boîtier 48 peut être mise en œuvre, par exemple, par collage, soit au moyen d'un adhésif, soit au moyen d'une couche de colle, par vissage, par encliquetage élastique ou par emboîtement.

Avantageusement, le dispositif d'alimentation en énergie électrique 31 comprend, en outre, au moins une batterie 46. La batterie 46 est configurée pour alimenter, autrement dit alimente, en énergie électrique l'actionneur électromécanique 11, en particulier l'unité électronique de contrôle 15 et le moteur électrique 16.

A la figure 2, la batterie 46 est disposée dans le boîtier 48. Dans ce cas, la batterie 46 est à l'extérieur du caisson 9, étant donné que le dispositif d'alimentation en énergie électrique 31 est à l'extérieur du caisson 9.

En variante, non représentée, la batterie 46 peut être disposée au niveau du caisson 9, en particulier à l'intérieur du caisson 9, à l'intérieur du tube d'enroulement 4 tout en étant à l'extérieur du carter 17 de l'actionneur électromécanique 11, ou à l'intérieur du carter 17 de l'actionneur électromécanique 11, en particulier dans la configuration assemblée de l'actionneur électromécanique 11. Dans ce dernier cas, l'actionneur électromécanique 11 comprend la batterie 46.

Ici, la batterie 46 est de type rechargeable.

Avantageusement, le panneau photovoltaïque 25 est configuré pour alimenter, autrement dit alimente, en énergie électrique la batterie 46.

Ainsi, le rechargement de la batterie 46 est mis en œuvre par énergie solaire, au moyen du panneau photovoltaïque 25.

De cette manière, le dispositif d'alimentation en énergie électrique 31 permet d'alimenter en énergie électrique l'actionneur électromécanique 11 et, plus particulièrement, l'unité électronique de contrôle 15 et le moteur électrique 16 au moyen de la batterie 46 et du panneau photovoltaïque 25, sans que l'actionneur électromécanique 11 soit relié électriquement à un réseau d'alimentation électrique du secteur.

Avantageusement, le dispositif d'alimentation en énergie électrique 31 comprend, en outre, le câble d'alimentation électrique 18.

A la figure 2, le câble d'alimentation électrique 18 relie électriquement le dispositif d'alimentation en énergie électrique 31, en particulier la batterie 46, à l'unité électronique de contrôle 15, pouvant être disposée soit à l'intérieur soit à l'extérieur du carter 17 de l'actionneur électromécanique 11. Le panneau photovoltaïque 25 est relié électriquement à la batterie 46, par une liaison électrique L46-25, étant donné que la batterie 46 est disposée à l'intérieur du boîtier 48 du dispositif d'alimentation en énergie électrique 31. Le câble d'alimentation électrique 18 permet l'alimentation en énergie électrique de l'actionneur électromécanique 11, notamment l'alimentation en énergie électrique de l'unité électronique de contrôle 15 et du moteur électrique 16.

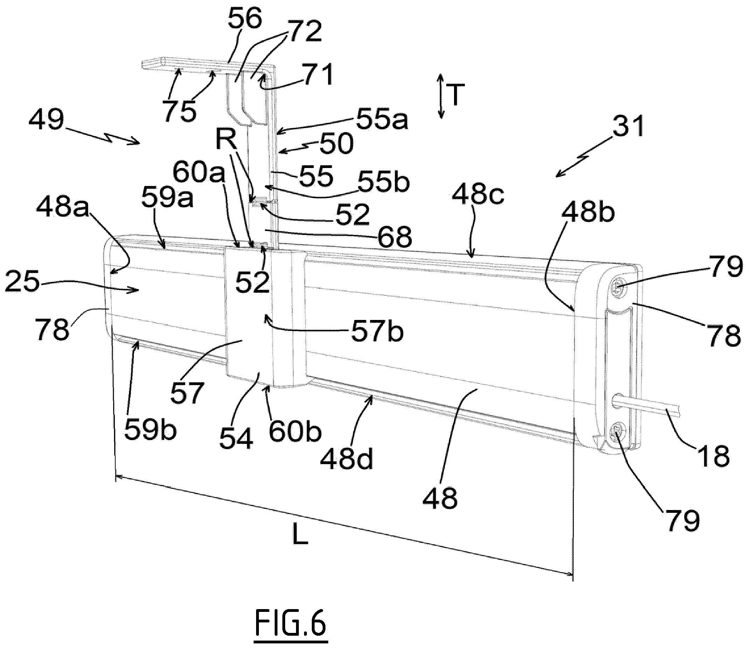

En variante, telle qu'illustré aux figures 5 et 6, le câble d'alimentation électrique 18 relie électriquement le panneau photovoltaïque 25 à l'actionneur électromécanique 11, en particulier à l'unité électronique de contrôle 15, dans le cas où la batterie 46 est disposée à l'extérieur du boîtier 48 du dispositif d'alimentation en énergie électrique 31 et, éventuellement, à l'intérieur du carter 17 de l'actionneur électromécanique 11. Dans ce cas, une liaison électrique, non représentée, est mise en œuvre entre l'unité électronique de contrôle 15 et la batterie 46.

En variante, non représentée, le câble d'alimentation électrique 18 relie électriquement le panneau photovoltaïque 25 à la batterie 46, dans le cas où la batterie 46 est disposée à l'extérieur du boîtier 48 du dispositif d'alimentation en énergie électrique 31, ainsi qu'à l'extérieur du carter 17 de l'actionneur électromécanique 11.

En variante, non représentée, le câble d'alimentation électrique 18 relie électriquement le panneau photovoltaïque 25 à l'unité électronique de contrôle 15 et à la batterie 46, dans le cas où la batterie 46 est disposée à l'extérieur du boîtier 48 du dispositif d'alimentation en énergie électrique 31, ainsi qu'à l'extérieur du carter 17 de l'actionneur électromécanique 11. Dans ce cas, le câble d'alimentation électrique 18 présente plusieurs branches, notamment au nombre de trois et pouvant être, par exemple, en forme de « Y ».

Avantageusement, le câble d'alimentation électrique 18 comprend au moins un connecteur électrique, non représenté. En outre, le connecteur électrique ou l'un des connecteurs électriques coopère, autrement dit est configuré pour coopérer, avec un autre connecteur électrique, non représenté, de l'actionneur électromécanique 11, de la batterie 46 ou de l'unité électronique de contrôle 15, en particulier dans la configuration assemblée du dispositif d'entraînement motorisé 5.

Avantageusement, lorsque le support de couple 21 comprend un dispositif d'affichage, le paramètre de fonctionnement que ce dispositif d'affichage permet de visualiser est un état de charge de la batterie 46.

Avantageusement, la batterie 46 comprend une pluralité d'éléments de stockage d'énergie 47, en particulier reliés électriquement en série. Les éléments de stockage d'énergie 47 de la batterie 46 peuvent être, notamment, des accumulateurs rechargeables.

Avantageusement, le panneau photovoltaïque 25 comprend la pluralité de cellules photovoltaïques 43. Dans ce cas, la batterie 46 est alimentée en énergie électrique au moyen des cellules photovoltaïques 43 du panneau photovoltaïque 25. Seules certaines cellules photovoltaïques 43 sont représentées à la figure 5, qui est une vue par l'avant du panneau photovoltaïque 25.

Le dispositif d'entraînement motorisé 5, en particulier le panneau photovoltaïque 25 et/ou l'unité électronique de contrôle 15, comprend des éléments de chargement configurés pour charger la batterie 46, à partir de l'énergie solaire récupérée par le panneau photovoltaïque 25. Dans ce cas, le courant circule entre les composants 25, 46 et 15 à travers une liaison filaire, au moins en partie au moyen du câble d'alimentation électrique 18.

Ainsi, les éléments de chargement configurés pour charger la batterie 46, à partir de l'énergie solaire, permettent de convertir l'énergie solaire récupérée par le panneau photovoltaïque 25 en énergie électrique.

En variante ou en complément, le dispositif d'entraînement motorisé 5, en particulier l'actionneur électromécanique 11, est alimenté en énergie électrique à partir de la batterie 46, à partir d'une batterie auxiliaire, non représentée, ou à partir d'un réseau d'alimentation électrique du secteur, en particulier par le réseau alternatif commercial, notamment en fonction d'un état de charge de la batterie 46.

Dans le cas où l'unité électronique de contrôle 15 comprend la première carte électronique 15a et la deuxième carte électronique, non représentée, la première carte électronique 15a est configurée pour contrôler, autrement dit contrôle, le moteur électrique 16 et la deuxième carte électronique est configurée pour permettre la recharge de la batterie 46 et/ou accéder à des fonctions de paramétrage et/ou de configuration de l'actionneur électromécanique 11, au moyen du ou des dispositifs de sélection 41 et, éventuellement, du ou des dispositifs d'affichage. Les éléments de chargement de la batterie 46 peuvent être disposés au niveau de la deuxième carte électronique.

En variante, dans le cas où l'unité électronique de contrôle 15 comprend une seule carte électronique, la seule carte électronique est configurée pour contrôler le moteur électrique 16, pour permettre la recharge de la batterie 46 et, éventuellement, accéder à des fonctions de paramétrage et/ou de configuration de l'actionneur électromécanique 11, au moyen du ou des dispositifs de sélection et, éventuellement, du ou des dispositifs d'affichage. Les éléments de chargement de la batterie 46 peuvent être disposés au niveau de la seule carte électronique.

On décrit à présent plus en détails, en référence aux figures 5 à 10, le dispositif d'alimentation en énergie électrique 31, illustré schématiquement à la figure 2 et de façon plus réaliste aux figures 5 à 10.

Le dispositif de fixation 49 comprend au moins un support de fixation 50 et un dispositif de maintien 51.

Le support de fixation 50 comprend au moins une pluralité de premiers éléments de verrouillage 52, comme illustré aux figures 6 et 8 à 10.

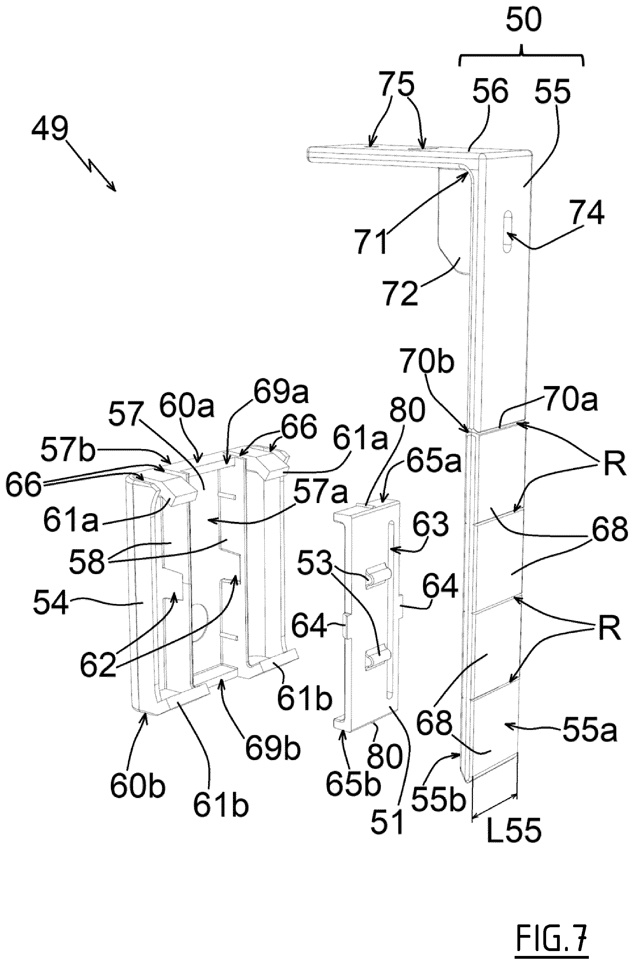

Le dispositif de maintien 51 comprend au moins un deuxième élément de verrouillage 53, comme illustré aux figures 7, 9 et 10. Le ou chaque deuxième élément de verrouillage 53 coopère, autrement dit est configuré pour coopérer, avec l'un des premiers éléments de verrouillage 52, en particulier dans la configuration assemblée du dispositif d'alimentation en énergie électrique 31.

Ici, le dispositif de maintien 51 comprend deux deuxièmes éléments de verrouillage 53.

Le nombre de deuxièmes éléments de verrouillage du dispositif de maintien n'est pas limitatif et peut être différent. Il peut être, notamment, égal à un ou supérieur ou égal à trois.

Le dispositif de fixation 49 comprend, en outre, un capot 54.

Le dispositif de maintien 51 est fixé, en particulier de manière démontable, autrement dit est configuré pour être fixé ou assemblé, sur le capot 54, en particulier dans la configuration assemblée du dispositif d'alimentation en énergie électrique 31.

Le capot 54 est fixé de manière démontable, autrement dit est configuré pour être fixé de manière démontable, sur le boîtier 48, en particulier dans la configuration assemblée du dispositif d'alimentation en énergie électrique 31.

En outre, en particulier dans la configuration assemblée du dispositif d'alimentation en énergie électrique 31, le support de fixation 50 est disposé, autrement dit est configuré pour être disposé, entre le boîtier 48 et le capot 54, de sorte, d'une part, à pouvoir coulisser le support de fixation 50 entre le boîtier 48 et le capot 54 suivant un mouvement de translation T et, d'autre part, à maintenir en position le support de fixation 50 par le dispositif de maintien 51, lors de la coopération du ou de chaque deuxième élément de verrouillage 53 avec l'un des premiers éléments de verrouillage 52.

Ainsi, cette construction du dispositif d'alimentation en énergie électrique 31 permet de dissocier intégralement le dispositif de fixation 49 par rapport au boîtier 48, sur lequel est fixé le panneau photovoltaïque 25.

De cette manière, cette construction du dispositif d'alimentation en énergie électrique 31 permet de régler la position du panneau photovoltaïque 25 par rapport au support de fixation 50 au moyen de différents crans de réglage obtenus par la coopération du ou de chaque deuxième élément de verrouillage 53 du dispositif de maintien 51 coopérant avec l'un des premiers éléments de verrouillage 52 du support de fixation 50.

Le réglage de la position du panneau photovoltaïque 25 par rapport au support de fixation 50 est donc mis en œuvre sans vis de réglage.

Par conséquent, le réglage de la position du panneau photovoltaïque 25 par rapport au support de fixation 50 est mis en œuvre de manière simple et sans avoir recours à un outil, tel que, par exemple, un tournevis.

En outre, le panneau photovoltaïque 25 est suspendu par rapport au support de fixation 50 par l'intermédiaire du boîtier 48, du dispositif de maintien 51 et du capot 54.

Par ailleurs, le panneau photovoltaïque 25 peut être monté sur le support de fixation 50 ou détaché du support de fixation 50 en faisant coulisser, suivant le mouvement de translation T, un sous-ensemble formé par le panneau photovoltaïque 25, le boîtier 48, le dispositif de maintien 51 et le capot 54 par rapport au support de fixation 50.

Avantageusement, le dispositif de fixation 49 comprend un seul support de fixation 50.

Ainsi, le coût d'obtention du dispositif de maintien 51 est minimisé. Avantageusement, le support de fixation 50 est réalisé dans une matière plastique.

A titre d'exemple nullement limitatif, la matière plastique du support de fixation 50 est du Poly-Butylène Téréphtalate, également appelé PBT, du poly-acétal, également appelé POM, du PolyAmide 6, également appelé polycaprolactame ou PA 6, du PolyAmide 6.6, également appelé polyhexaméthylène adipamide ou PA 6.6.

Ici, le dispositif de maintien 51 comprend deux deuxièmes éléments de verrouillage 53. En outre, chacun des deuxièmes éléments de verrouillage 53 coopère, autrement dit est configuré pour coopérer, avec l'un des premiers éléments de verrouillage 52 du support de fixation 50, en particulier dans la configuration assemblée du dispositif d'alimentation en énergie électrique 31.

Ainsi, le support de fixation 50 est maintenu en position par rapport au capot 54 et au boîtier 48 suite au positionnement des deux deuxièmes éléments de verrouillage 53 du dispositif de maintien 51 par rapport à deux premiers éléments de verrouillage 52 du support de fixation 50.

De cette manière, le positionnement des deux deuxièmes éléments de verrouillage 53 par rapport à deux premiers éléments de verrouillage 52 permet d'améliorer la robustesse du maintien en position du support de fixation 50 par rapport au capot 54 et au boîtier 48.

Ici, le support de fixation 50 comprend quatre premiers éléments de verrouillage 52.

Ainsi, le nombre de positions de réglage du support de fixation 50 par rapport au capot 54 et au boîtier 48 est égal à trois, dans le cas où les deux deuxièmes éléments de verrouillage 53 du dispositif de maintien 51 sont positionnés par rapport à deux premiers éléments de verrouillage 52 du support de fixation 50.

Le nombre de premiers éléments de verrouillage n'est pas limitatif et peut être différent. Il peut être, par exemple, égal à deux, à trois ou supérieur ou égal à cinq.

Le nombre de positions de réglage du support de fixation 50 par rapport au capot 54 et au boîtier 48 est dépendant du nombre de premiers éléments de verrouillage 52 du support de fixation 50.

Ici, le ou chaque premier élément de verrouillage 52 est un élément en creux, autrement dit une cavité. En outre, le ou chaque deuxième élément de verrouillage 53 est un élément en saillie, autrement dit un godron.

A titre d'exemple nullement limitatif, la section de l'élément en creux formant le ou chaque premier élément de verrouillage 52 est de forme triangulaire. En outre, la section de l'élément en saillie formant le ou chaque deuxième élément de verrouillage 53 est de forme semi-circulaire.

En variante, non représentée, le ou chaque premier élément de verrouillage 52 est un élément en saillie, autrement dit un godron. Dans ce cas, le ou chaque deuxième élément de verrouillage 53 est un élément en creux, autrement dit une cavité.

Ici, le support de fixation 50 est une équerre de fixation.

Avantageusement, le support de fixation 50 comprend une première paroi 55 et une deuxième paroi 56.

Avantageusement, la deuxième paroi 56 est reliée à la première paroi 55, de sorte à former un coin 71 entre la deuxième paroi 56 et la première paroi 55.

Ici, la deuxième paroi 56 est orthogonale à la première paroi 55.

En variante, non représentée, la deuxième paroi 56 est inclinée par rapport à la première paroi 55 d'un angle dont la valeur est soit strictement inférieure à 90° et strictement supérieure à 0°, préférentiellement strictement supérieure à 80°, soit strictement supérieure à 90° et strictement à inférieure à 180°, préférentiellement strictement inférieure à 100°.

Avantageusement, la première paroi 55 s'étend selon une direction verticale, en particulier dans une configuration assemblée du dispositif de fixation 49 par rapport à l'installation d'occultation 6. En outre, la deuxième paroi 56 s'étend selon une direction horizontale, en particulier dans la configuration assemblée du dispositif de fixation 49 par rapport à l'installation d'occultation 6.

Avantageusement, le support de fixation 50 est fixé sur une paroi, appelée par la suite paroi fixe, pouvant être, par exemple, une paroi, non représentée, du caisson 9, le mur M du bâtiment B, le plafond P du bâtiment B ou le cadre dormant 76 de la fenêtre 40.

Avantageusement, en fonction de la paroi fixe sur laquelle le support de fixation 50 est fixé, la première paroi 55 du support de fixation 50 s'étend soit selon une direction verticale, notamment lorsque le support de fixation 50 est fixé au caisson 9 ou au plafond P du bâtiment B, soit selon une direction horizontale, notamment lorsque le support de fixation 50 est fixé au mur M du bâtiment B ou au cadre dormant 76 de la fenêtre 40.

Ici, la fixation du support de fixation 50 sur la paroi fixe est mise en œuvre par vissage, en l'occurrence au moyen d'une ou plusieurs vis de fixation 73.

Avantageusement, la première paroi 55 du support de fixation 50 comprend au moins un premier trou 74.

Ici et comme illustré aux figures 5, 7, 9 et 10, la première paroi 55 comprend un seul premier trou 74. Le premier trou 74 est de section oblongue, en particulier avec sa plus grande dimension parallèle à une longueur de la première paroi 55.

Ici, la fixation du support de fixation 50 sur la paroi fixe, en l'occurrence dans le caisson 9, comme illustré à la figure 10, est mise en œuvre par une vis de fixation 73 traversant le premier trou 74 et se vissant dans un trou de fixation de la paroi fixe.

Avantageusement, la deuxième paroi 56 du support de fixation 50 comprend au moins un deuxième trou 75.

Ici et comme illustré aux figures 5 à 8, la deuxième paroi 56 comprend deux deuxièmes trous 75. L'un des deuxième trous 75 est de section circulaire et l'autre des deuxièmes trous 75 est de section oblongue, en particulier avec sa plus grande dimension perpendiculaire à une longueur de la deuxième paroi 56.

Ici, la fixation du support de fixation 50 sur la paroi fixe, en l'occurrence le plafond P du bâtiment B, comme illustré à la figure 9, est mise en œuvre par deux vis de fixation 73 traversant respectivement l'un des deuxièmes trous 75 et se vissant dans la paroi fixe ou, en variante, non représentée, dans une cheville, qui est fixée dans la paroi fixe.

Avantageusement, les premiers éléments de verrouillage 52 sont ménagés dans la première paroi 55 du support de fixation 50.

Avantageusement, la fixation du capot 54 sur le boîtier 48 est mise en œuvre par encliquetage élastique.

Avantageusement, le boîtier 48 comprend au moins une première rainure 59a et une deuxième rainure 59b.

Ici, les première et deuxième rainures 59a, 59b s'étendent suivant une largeur L du boîtier 48 entre les première et deuxième extrémités 48a, 48b du boîtier 48 et, avantageusement, sur toute la largeur L du boîtier 48.

Avantageusement, le boîtier 48 comprend un premier bord 48c, pouvant également être appelé « bord supérieur », et un deuxième bord 48d, pouvant également être appelé « bord inférieur ». Le deuxième bord 48d est opposé au premier bord 48c. En outre, la première rainure 59a est disposée au voisinage du premier bord 48c et la deuxième rainure 59b est disposée au voisinage du deuxième bord 48d.

Ici et comme illustré aux figures 5 et 6, le support de fixation 50 est disposé de manière centrée par rapport au boîtier 48, suivant la largeur L du boîtier 48 entre les première et deuxième extrémités 48a, 48b du boîtier 48.

Avantageusement, le capot 54 comprend au moins un premier bord 60a et un deuxième bord 60b. Le deuxième bord 60b est opposé au premier bord 60a.

Avantageusement, le capot 54 comprend, en outre, au moins une encoche 69a, 69b. En outre, le support de fixation 50, en particulier la première paroi 55 du support de fixation 50, est configuré pour coulisser, autrement dit coulisse, entre le boîtier 48 et le capot 54 suivant le mouvement de translation T au travers de la ou de chaque encoche 69a, 69b.

Ici, le capot 54 comprend une première encoche 69a ménagée au niveau du premier bord 60a du capot 54 et une deuxième encoche 69b ménagée au niveau du deuxième bord 60b du capot 54.

Ainsi, lors du coulissement du support de fixation 50 par rapport au capot 54 et au boîtier 48 suivant le mouvement de translation T ou lors du maintien en position du support de fixation 50 par rapport au capot 54 et au boîtier 48, le support de fixation 50, en particulier la première paroi 55 du support de fixation 50, s'étend au travers de la première encoche 69a du capot 54 et, éventuellement, au travers de la deuxième encoche 69b du capot 54.

En variante, non représentée, le capot 54 comprend une seule encoche 69a, 69b, qui est ménagée soit au niveau du premier bord 60a du capot 54 soit au niveau du deuxième bord 60b du capot 54. Ainsi, lors du coulissement du support de fixation 50 par rapport au capot 54 et au boîtier 48 suivant le mouvement de translation T ou lors du maintien en position du support de fixation 50 par rapport au capot 54 et au boîtier 48, le support de fixation 50, en particulier la première paroi 55 du support de fixation 50, s'étend au travers de l'unique encoche 69a, 69b du capot 54.

Avantageusement, le capot 54 comprend, en outre, au moins un premier ergot 61a et au moins un deuxième ergot 61b. Le ou chaque premier ergot 61a est disposé le long du premier bord 60a du capot 54. Le ou chaque deuxième ergot 61b est disposé le long du deuxième bord 60b du capot 54. En outre, le ou chaque premier ergot 61a est déformable élastiquement.

Avantageusement, la fixation du capot 54 sur le boîtier 48 est mise en œuvre par l'insertion du ou de chaque premier ergot 61a dans la première rainure 59a et par l'insertion du ou de chaque deuxième ergot 61b dans la deuxième rainure 59b.

Ici, le capot 54 comprend deux premiers ergots 61a, qui sont disposés respectivement le long du premier bord 60a, et deux deuxièmes ergots 61b, qui sont disposés respectivement le long du deuxième bord 60b.

Avantageusement, les deux premiers ergots 61a sont disposés de part et d'autre de de la première encoche 69a. En outre, les deux deuxièmes ergots 61b sont disposés de part et d'autre de la deuxième encoche 69b.

Le nombre de premiers ergots et le nombre de deuxièmes ergots du capot ne sont pas limitatifs et peuvent être différents. Ils peuvent, par exemple, être égaux à un ou supérieurs ou égaux à trois.

Avantageusement, le capot 54 comprend, en outre, une échancrure 66 de chaque côté du ou de chaque premier ergot 61a.

Ainsi, l'échancrure 66 de chaque côté du ou de chaque premier ergot 61a permet de garantir une déformation élastique du ou de chaque premier ergot 61a, de sorte à fixer le capot 54 sur le boîtier 48 par encliquetage élastique.

En variante, non représentée, le ou chaque deuxième ergot 61b est déformable élastiquement. Dans ce cas, le capot 54 comprend, en outre, en complément ou en remplacement de l'échancrure 66 de chaque côté du ou de chaque premier ergot 61a, une échancrure 66 de chaque côté du ou de chaque deuxième ergot 61b.

Le caractère déformable des premiers et/ou des deuxième ergots 61a, 61b facilite le montage du capot 54 sur le boîtier 48, en particulier par encliquetage élastique, ainsi que son démontage.

Avantageusement, le capot 54 comprend, en outre, deux découpes 62.

Avantageusement, le dispositif de maintien 51 comprend, en outre, deux éléments en saillie 64 et au moins une fente 63. Chaque élément en saillie 64 est logé, autrement dit est configuré pour être logé, à l'intérieur de l'une des découpes 62 du capot 54, en particulier dans la configuration montée du dispositif de maintien 51 dans le capot 54, par conséquent dans la configuration assemblée du dispositif de fixation 49.

Avantageusement, le capot 54 comprend, en outre, une paroi 57 et deux nervures 58. En outre, chaque nervure 58 comprend au moins l'une des découpes 62.

Avantageusement, la paroi 57 du capot 54 comprend une face extérieure 57a et une face intérieure 57b. La face intérieure 57b est opposée à la face extérieure 57a.

Avantageusement, chaque découpe 62 s'étend à partir de l'une des nervures 58 jusqu'à la face intérieure 57b de la paroi 57 du capot 54.

Avantageusement, une partie du dispositif de maintien 51 est déformée élastiquement au moyen de la fente 63, lors de l'insertion de chaque élément en saillie 64 à l'intérieur de l'une des découpes 62 du capot 54.

Ainsi, l'assemblage du dispositif de maintien 51 par rapport au capot 54 est mis en œuvre par une déformation élastique d'une partie de celui-ci, au moyen de la fente 63, de sorte à insérer chaque élément en saillie 64 du dispositif de maintien 51 à l'intérieur de l'une des découpes 62 du capot 54.

Avantageusement, l'insertion de chaque élément en saillie 64 du dispositif de maintien 51 à l'intérieur de l'une des découpes 62 du capot 54 est mise en œuvre par la déformation élastique du dispositif de maintien 51, au moyen de la fente 63.

Ainsi, lorsqu'un effort de déformation élastique exercé sur le dispositif de maintien 51, en particulier par pincement au niveau de la fente 63, est relâché, autrement dit lorsque le dispositif de maintien 51 ne subit plus de d'effort de déformation élastique, chaque élément en saillie 64 inséré à l'intérieur de l'une des découpes 62 permet de garantir le maintien en position du dispositif de maintien 51 par rapport au capot 54.

En variante ou en complément, l'insertion de chaque élément en saillie 64 du dispositif de maintien 51 à l'intérieur de l'une des découpes 62 du capot 54 est mise en œuvre par une déformation élastique par écartement des deux nervures 58 comprenant respectivement les découpes 62.

Ainsi, lorsqu'une effort de déformation élastique exercé sur les nervures 58 du capot 54 est relâché, autrement dit lorsque les nervures 58 du capot 54 ne subissent plus de déformation élastique provenant des éléments en saillie 64 du dispositif de maintien 51, chaque élément en saillie 64 inséré à l'intérieur de l'une des découpes 62 permet de garantir le maintien en position du dispositif de maintien 51 par rapport au capot 54.

Avantageusement, le dispositif de maintien 51 est disposé, autrement dit est configuré pour être disposé, entre les premier et deuxième bords 60a, 60b du capot 54, en particulier dans la configuration assemblée du dispositif de fixation 49.

Avantageusement, le dispositif de maintien 51 comprend, en outre, une première bordure 65a et une deuxième bordure 65b. La deuxième bordure 65b est opposée à la première bordure 65a. En outre, en particulier dans la configuration assemblée du dispositif de fixation 49, la première bordure 65a du dispositif de maintien 51 est disposée, autrement dit est configurée pour être disposée, en vis-à-vis du premier bord 60a du capot 54 et la deuxième bordure 65b du dispositif de maintien 51 est disposée, autrement dit est configurée pour être disposée, en vis-à-vis du deuxième bord 60b du capot 54.

Avantageusement, chacune des première et deuxième bordures 65a, 65b du dispositif de maintien 51 est en appui, autrement dit est configurée pour être en appui, contre l'un des premier et deuxième bords 60a, 60b du capot 54, en particulier dans la configuration assemblée du dispositif de fixation 49.

Avantageusement, la mise en appui de chacune des première et deuxième bordures 65a, 65b du dispositif de maintien 51 contre l'un des premier et deuxième bords 60a, 60b du capot 54 est mis en œuvre au moyen d'au moins un godron 80 ménagé sur chacune des première et deuxième bordures 65a, 65b.

Ici, chacune des première et deuxième bordures 65a, 65b du dispositif de maintien 51 comprend un seul godron 80.

Le nombre de godrons de chacune des première et deuxième bordures du dispositif de maintien n'est pas limitatif et peut être différent. Il peut être, par exemple, supérieur ou égal à deux.

Avantageusement, chacune des première et deuxième bordures 65a, 65b du dispositif de maintien 51 est, en outre, en appui, autrement dit est configurée pour être, en outre, en appui, contre la face intérieure 57b de la paroi 57 du capot 54, en particulier dans la configuration assemblée du dispositif de fixation 49.

Avantageusement, le support de fixation 50 est sécable au moyen de lignes de brisure R.

Avantageusement, chacune des lignes de brisure R s'étend au travers de l'un des premiers éléments de verrouillage 52 du support de fixation 50.

Ainsi, le support de fixation 50 présente des parties sécables 68 permettant de supprimer l'une ou plusieurs de celles-ci, au moyen des lignes de brisure R. La ou les parties sécables 68 à supprimer sont délimitées par l'un des premiers éléments de verrouillage 52 qui est inutilisé pour garantir le maintien en position du support de fixation 50 par rapport au dispositif de maintien 51.

De cette manière, l'aspect esthétique du dispositif de fixation 49 est amélioré en retirant une ou plusieurs parties sécables 68, de sorte à éviter un dépassement du support de fixation 50, en particulier de la première paroi 55 du premier support de fixation 50, par rapport au capot 54, en particulier au travers de la deuxième encoche 69b.

Avantageusement, les lignes de brisure R sont ménagées dans la première paroi 55 du support de fixation 50.

Avantageusement, chacune des lignes de brisure R s'étend suivant une largeur L55 de la première paroi 55 du support de fixation 50 et, préférentiellement, sur toute la largeur L55 de la première paroi 55.

Ici, chacune des lignes de brisure R est réalisée par au moins un sillon 70a, 70b.

Avantageusement, la première paroi 55 du support de fixation 50 comprend une première face 55a et une deuxième face 55b. La deuxième face 55b est opposée à la première face 55a.

Avantageusement, chacune des lignes de brisure R comprend un premier sillon 70a ménagé sur la première face 55a de la première paroi 55 et un deuxième sillon 70b ménagé sur la deuxième face 55b de la première paroi 55. Le deuxième sillon 70b est disposé en vis-à-vis du premier sillon 70a, en particulier selon la longueur de la première paroi 55.

Avantageusement, le support de fixation 50 comprend, en outre, au moins une butée 72. La ou chaque butée 72 est ménagée dans le coin 71 du support de fixation 50.

Ainsi, la ou chaque butée 72 permet de renforcer le support de fixation 50 au niveau de la jonction entre les première et deuxième parois 55, 56.

Ici, le support de fixation 50 comprend deux butées 72, dont une seule est représentée aux figures 5, 7, 9 et 10. En outre, chacune des butées 72 est ménagée dans le coin 71 du support de fixation 50.

Le nombre de butées n'est pas limitatif et peut être différent. Il peut, par exemple, être égal à un ou supérieur ou égal à trois.

Dans l'exemple de réalisation illustré à la figure 10, le caisson 9 est en appui, autrement dit est configuré pour être en appui, contre la ou chaque butée 72, en particulier dans la configuration assemblée du dispositif d'occultation 3.

Ainsi, la ou chaque butée 72 permet de garantir un écartement entre le caisson 9 et le support de fixation 50, en particulier entre le caisson 9 et la première paroi 55 du support de fixation 50.

De cette manière, l'écartement entre le caisson 9 et le support de fixation 50 garanti par la ou chaque butée 72 permet d'éviter que la ou les vis de fixation 73 ne puissent être en contact avec l'écran 2, bien que celles-ci peuvent dépasser à l'intérieur du caisson 9.

En outre, le positionnement du caisson 9 contre les deux butées 72 du support de fixation 50 permet de garantir le parallélisme entre le caisson 9 et la première paroi 55 du support de fixation 50.

Grâce à la présente invention, la construction du dispositif d'alimentation en énergie électrique permet de dissocier intégralement le dispositif de fixation par rapport au boîtier, sur lequel est fixé le panneau photovoltaïque.

De nombreuses modifications peuvent être apportées aux exemples de réalisation décrits précédemment, sans sortir du cadre de l'invention défini par les revendications.

En variante, non représentée, dans le cas où le panneau photovoltaïque 25 est fixé sur le boîtier 48, la liaison électrique entre le câble d'alimentation électrique 18 et le panneau photovoltaïque 25 est mise en œuvre par l'assemblage d'un connecteur électrique du câble d'alimentation électrique 18 sur un autre connecteur électrique du panneau photovoltaïque 25.

En variante, non représentée, l'unité électronique de contrôle 15 comprend, en outre, un boîtier. En outre, la première carte électronique 15a est disposée à l'intérieur du boîtier, en particulier dans une configuration assemblée de l'unité électronique de contrôle 15. Ainsi, le boîtier de l'unité électronique de contrôle 15 permet de protéger la première carte électronique 15a, lors de l'assemblage de l'actionneur électromécanique 11 et suite à l'assemblage de ce dernier. De cette manière, le boîtier de l'unité électronique de contrôle 15 permet d'isoler électriquement la première carte électronique 15a par rapport au carter 17. Avantageusement, le diamètre extérieur du boîtier de l'unité électronique de contrôle 15 est inférieur au diamètre intérieur du carter 17, de sorte que le boîtier peut être inséré dans le carter 17, lors de l'assemblage de l'actionneur électromécanique 11. Dans un premier cas, le boîtier de l'unité électronique de contrôle 15 peut comprendre deux demi-coques configurées pour coopérer ensemble, en particulier dans la configuration assemblée de l'unité électronique de contrôle 15. Dans la configuration assemblée de l'actionneur électromécanique 11, les deux demi-coques sont assemblées entre elles, de sorte à définir un plan de jonction s'étendant suivant une direction parallèle à l'axe de rotation X. Avantageusement, au moins l'une des deux demi-coques formant le boîtier comprend des éléments de positionnement et de fixation de la première carte électronique 15a, en particulier dans la configuration assemblée de l'unité électronique de contrôle 15. Dans un deuxième cas, le boîtier de l'unité électronique de contrôle 15 peut comprendre un ou plusieurs tronçons, le ou chaque tronçon étant réalisé sous la forme d'un tube creux. Le ou chaque tronçon est configuré pour loger ou recevoir, autrement dit loge ou reçoit, la première carte électronique 15a, en particulier dans la configuration assemblée de l'unité électronique de contrôle 15. Dans un tel cas, le ou chaque tronçon du boîtier comprend une première rainure et une deuxième rainure. En outre, les première et deuxième rainures sont configurées pour maintenir en position, autrement dit maintiennent en position, la première carte électronique 15a à l'intérieur du boîtier, en particulier dans la configuration assemblée de l'unité électronique de contrôle 15.

En variante, non représentée, le dispositif d'alimentation en énergie électrique 31 comprend, en outre, un chargeur. Le chargeur est configuré pour être relié électriquement, autrement dit est relié électriquement, à la batterie 46, soit directement, soit au travers de l'actionneur électromécanique 11 et/ou de l'unité électronique de contrôle 15. Le chargeur est configuré pour être branché, autrement dit est branché, sur une prise électrique murale, de sorte à recharger la batterie 46 à partir d'un réseau d'alimentation électrique du secteur. Ce chargeur forme une source d'alimentation en énergie électrique externe.

En variante, non représentée, le dispositif d'alimentation en énergie électrique 31 comprend, en outre, une batterie auxiliaire, la batterie auxiliaire étant configurée pour recharger la batterie 46. La batterie auxiliaire est configurée pour être reliée électriquement, autrement dit est reliée électriquement, à la batterie 46, soit directement, soit au travers de l'actionneur électromécanique 11 et/ou de l'unité électronique de contrôle 15. Ainsi, la batterie 46 peut être rechargée au moyen de la batterie auxiliaire formant une source d'alimentation en énergie électrique externe, en particulier dans le cas où le dispositif d'occultation 3 est éloigné d'une prise électrique murale. En outre, la batterie auxiliaire peut permettre de recharger une batterie d'autres équipements électriques, notamment nomades, tels que, par exemple, un téléphone portable ou un ordinateur portable.

En variante, non représentée, l'actionneur électromécanique 11 est inséré dans un rail, en particulier de section carrée ou rectangulaire, pouvant être ouvert à l'une ou à ses deux extrémités, en particulier dans la configuration assemblée du dispositif d'occultation 3. Par ailleurs, l'actionneur électromécanique 11 peut être configuré pour entraîner au moins un arbre d'entraînement sur lequel s'enroule des cordons de déplacement et/ou d'orientation de l'écran 2, qui peut, avantageusement, être un store à lames dans ce cas. Dans ce cas, le dispositif d'occultation 3 comprend une barre mobile ou une pluralité de barres mobiles, qui peuvent être toutes déplacées au moyen de l'actionneur électromécanique 11.

En outre, les modes de réalisation et variantes envisagés peuvent être combinés pour générer de nouveaux modes de réalisation de l'invention, sans sortir du cadre de l'invention défini par les revendications.

## Revendications

1. Dispositif d'alimentation en énergie électrique (31),
le dispositif d'alimentation en énergie électrique (31) comprenant au moins :
- un boîtier (48),
- un panneau photovoltaïque (25), le panneau photovoltaïque (25) étant fixé sur le boîtier (48), et
- un dispositif de fixation (49),
le dispositif de fixation (49) comprenant au moins :
- un support de fixation (50), le support de fixation (50) comprenant au moins une pluralité de premiers éléments de verrouillage (52), et
- un dispositif de maintien (51), le dispositif de maintien (51) comprenant au moins un deuxième élément de verrouillage (53), ledit au moins un deuxième élément de verrouillage (53) coopérant avec l'un des premiers éléments de verrouillage (52),
**caractérisé**
**en ce que** le dispositif de fixation (49) comprend, en outre, un capot (54),
**en ce que** le dispositif de maintien (51) est fixé sur le capot (54),
**en ce que** le capot (54) est fixé de manière démontable sur le boîtier (48),
et **en ce que** le support de fixation (50) est disposé entre le boîtier (48) et le capot (54), de sorte, d'une part, à pouvoir coulisser le support de fixation (50) entre le boîtier (48) et le capot (54) suivant un mouvement de translation (T) et, d'autre part, à maintenir en position le support de fixation (50) par le dispositif de maintien (51), lors de la coopération dudit au moins un deuxième élément de verrouillage (53) avec l'un des premiers éléments de verrouillage (52).

2. Dispositif d'alimentation en énergie électrique (31) selon la revendication 1, **caractérisé en ce que** la fixation du capot (54) sur le boîtier (48) est mise en œuvre par encliquetage élastique.

3. Dispositif d'alimentation en énergie électrique (31) selon la revendication 2, **caractérisé**
**en ce que** le boîtier (48) comprend au moins :
- une première rainure (59a), et
- une deuxième rainure (59b),
**en ce que** le capot (54) comprend au moins :
- un premier bord (60a),
- un deuxième bord (60b), le deuxième bord (60b) étant opposé au premier bord (60a),
- un premier ergot (61a), le ou chaque premier ergot (61a) étant disposé le long du premier bord (60a), le ou chaque premier ergot (61a) étant déformable élastiquement, et
- un deuxième ergot (61b), le ou chaque deuxième ergot (61b) étant disposé le long du deuxième bord (60b),
et **en ce que** la fixation du capot (54) sur le boîtier (48) est mise en œuvre par l'insertion du ou de chaque premier ergot (61a) dans la première rainure (59a) et par l'insertion du ou de chaque deuxième ergot (61b) dans la deuxième rainure (59b).

4. Dispositif d'alimentation en énergie électrique (31) selon l'une quelconque des revendications 1 à 3, **caractérisé**
**en ce que** le capot (54) comprend, en outre, deux découpes (62),
**en ce que** le dispositif de maintien (51) comprend, en outre, deux éléments en saillie (64) et au moins une fente (63), chaque élément en saillie (64) étant logé à l'intérieur de l'une des découpes (62),
et **en ce qu'**une partie du dispositif de maintien (51) est déformée élastiquement au moyen de la fente (63), lors de l'insertion de chaque élément en saillie (64) à l'intérieur de l'une des découpes (62) du capot (54).

5. Dispositif d'alimentation en énergie électrique (31) selon l'une quelconque des revendications 1 à 4, **caractérisé en ce que** le support de fixation (50) est sécable au moyen de lignes de brisure (R).

6. Dispositif d'alimentation en énergie électrique (31) selon la revendication 5, **caractérisé en ce que** chacune des lignes de brisure (R) s'étend au travers de l'un des premiers éléments de verrouillage (52).

7. Dispositif d'entraînement motorisé (5),
le dispositif d'entraînement motorisé (5) comprenant au moins :
- un actionneur électromécanique (11),
- une unité électronique de contrôle (15), et
- un dispositif d'alimentation en énergie électrique (31),
l'actionneur électromécanique (11) comprenant au moins un moteur électrique (16),
**caractérisé**
**en ce que** le dispositif d'alimentation en énergie électrique (31) est conforme à l'une quelconque des revendications 1 à 6,
**en ce que** le dispositif d'alimentation en énergie électrique (31) comprend, en outre, une batterie (46),
et **en ce que** l'unité électronique de contrôle (15) et le moteur électrique (16) sont alimentés en énergie électrique à partir de la batterie (46).

8. Dispositif d'entraînement motorisé (5) selon la revendication 7, **caractérisé en ce que** la batterie (46) est alimentée en énergie électrique au moyen du panneau photovoltaïque (25).

9. Dispositif d'occultation (3),
le dispositif d'occultation (3) comprenant au moins :
- un écran (2), et
- un dispositif d'entraînement motorisé (5),
**caractérisé en ce que** le dispositif d'entraînement motorisé (5) est conforme à la revendication 7 ou à la revendication 8, l'écran (2) étant configuré pour être entraîné en déplacement par l'actionneur électromécanique (11) du dispositif d'entraînement motorisé (5).

10. Dispositif d'occultation (3) selon la revendication 9, **caractérisé en ce que** le dispositif d'occultation (3) comprend, en outre, au moins un caisson (9), l'actionneur électromécanique (11) étant logé à l'intérieur du caisson (9),
**en ce que** le support de fixation (50) comprend au moins :
- une première paroi (55),
- une deuxième paroi (56), la deuxième paroi (56) étant reliée à la première paroi (55), de sorte à former un coin (71) entre la deuxième paroi (56) et la première paroi (55), et
- une butée (72), la ou chaque butée (72) étant ménagée dans le coin (71),
et **en ce que** le caisson (9) est en appui contre la ou chaque butée (72).
